(19) **Europäisches Patentamt**

**European Patent Office**

**Office européen des brevets**

(11) **EP 0 718 895 B1**

(12) **EUROPEAN PATENT SPECIFICATION**

(45) Date of publication and mention
of the grant of the patent:
**27.09.2000 Bulletin 2000/39**

(51) Int Cl.[7]: **H01L 29/788**, H01L 29/423,
H01L 21/336

(21) Application number: **95302992.3**

(22) Date of filing: **02.05.1995**

(54) **Non-volatile memory and method for manufacturing the same**

Nichtflüchtiger Speicher und dessen Herstellungsverfahren

Mémoire non-volatile et son procédé de fabrication

(84) Designated Contracting States:
**DE FR GB NL**

(30) Priority: **20.12.1994 JP 31710794**

(43) Date of publication of application:
**26.06.1996 Bulletin 1996/26**

(73) Proprietor: **SHARP KABUSHIKI KAISHA**
**Osaka-shi, Osaka-fu 545-0013 (JP)**

(72) Inventor: **Matsushita, Tadashi**
**Nara (JP)**

(74) Representative: **Brown, Kenneth Richard et al**
**R.G.C. Jenkins & Co.**
**26 Caxton Street**
**London SW1H 0RJ (GB)**

(56) References cited:
**GB-A- 2 073 484**      **US-A- 4 794 565**
**US-A- 4 878 101**      **US-A- 5 049 515**

**Description**

**SPECIFICATION**

**BACKGROUND OF THE INVENTION**

**1. Field of the Invention**

The present invention relates to a non-volatile memory and a method for manufacturing the same. More especially, the invention relates to an electrically writable and erasable non-volatile memory having a floating gate electrode, and a method for manufacturing the same.

More especially, the invention relates to a non-volatile memory comprising a hyperfine floating gate electrode, and a method for manufacturing the same.

**2. Description of the Related Art**

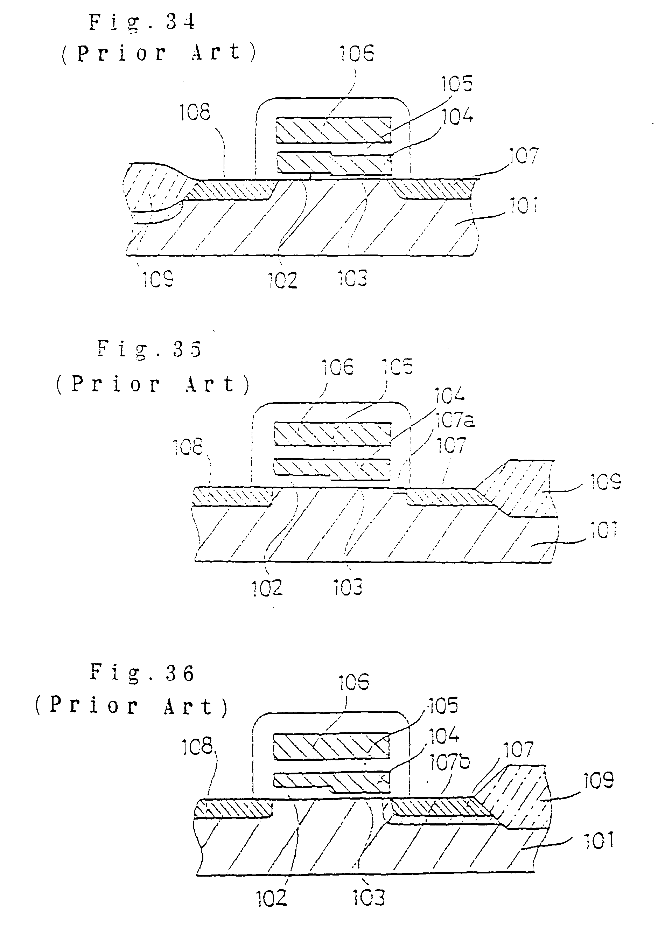

Various non-volatile semiconductor memory devices and methods for realizing the same have been proposed, which memories allow data to be electrically written therein and erased therefrom. One of the non-volatile memories noted quite recently uses what is called a hot electron injection. Such a non-volatile memory provides a floating gate electrode in a gate insulating film located under a control gate electrode wherein a high voltage is applied to a space between a source impurity diffusion region and a drain impurity diffusion region, and a high voltage is also applied to the control gate electrode so that hot carriers thus generated are absorbed by an electric field of the control gate electrode and are then injected into the floating gate electrode. For example, USP 4,963,825 and Japanese unexamined Patent Application No. SHO 61-127179 disclose non-volatile memories which are most noted as a memory having a typical structure. Figs. 34 through 36 show such typical structures of the non-volatile memory.

Figs. 34 through 36 are sectional views showing a structure of a so-called single memory cell of a self-aligned type which has the most simple structure among non-volatile memories. On a practical level, such non-volatile memories take more complicated structures, but for simplicity the non-volatile memory will be detailed with respect to Figs. 34 through 36. Referring to Figs. 34 through 36, reference numeral 101 designates a P-type semiconductor substrate, 102 a second gate insulating film, 103 a first gate insulating film, 104 a first polysilicon layer (floating gate electrode), 105 a third gate insulating film, 106 a second polysilicon layer (control gate electrode), 107 a source region ($N^+$ type impurity diffusion region), 108 a drain region ($N^+$ type impurity diffusion region), 109 a device isolation oxide film (LOCOS).

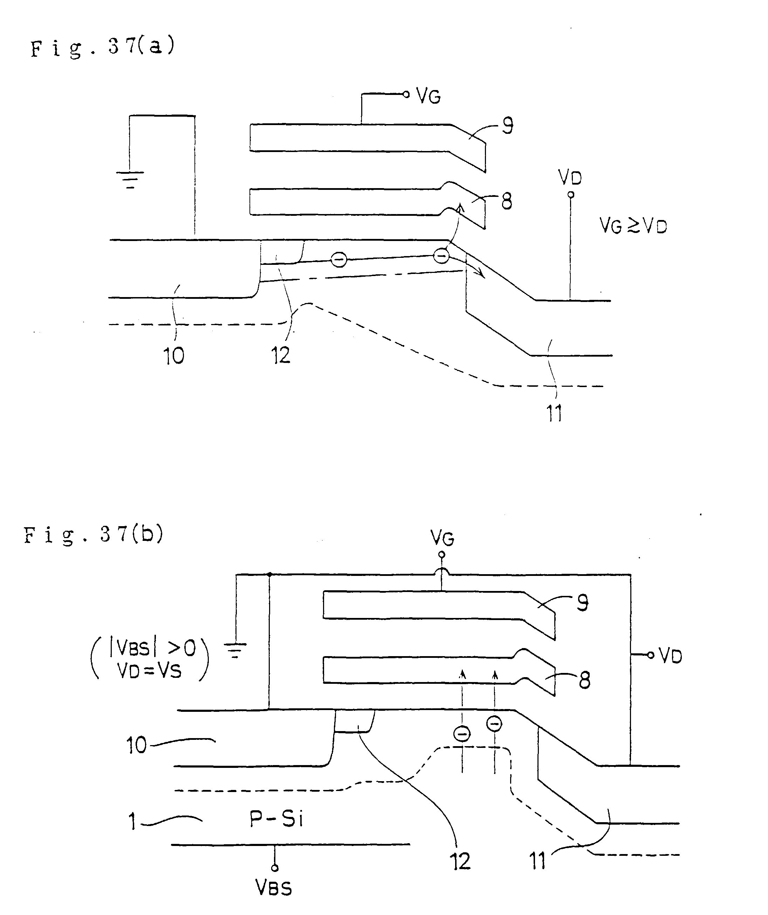

Such a structure is called a self-aligned type because the floating gate electrode 104 and the control gate electrode 106 are formed in such a manner that the floating gate electrode 104 and the control gate electrode 106 are flush at the ends thereof (in self-alignment) in the longitudinal direction of the channel. It is known that the source region 107 assumes a lightly doped drain (LDD) or a double doped drain (DDD) structure so that a pressure resistance is improved in the erasing operation. FIG. 35 shows the LDD structure whereas FIG. 36 the DDD structure.

The operation principle and the feature of the non-volatile memory will be briefly described hereinbelow. Data can be written into the memory cell when a high voltage is applied to the drain region 108 and the control gate electrode 106. The control gate electrode 106 absorbs carriers generated by an avalanche breakdown in a region joining with the drain region 108 in the channel, and then the floating gate electrode accumulates the carriers thus generated. On the other hand, data is erased from the memory cell by applying a high voltage to the source region with the control gate electrode 106 being grounded, and discharging by the Fowler-Nordheim (F-N) tunnel injection electric charges accumulated in the floating gate electrode 104. This operation discharges electric charges through the first gate insulating film 103 thinner than the second gate insulating film 102, which is very likely to cause the F-N tunneling injection. Besides, increasing the thickness of the second gate insulating film 102 prevents erroneous data erasure caused by the read disturb mode from the drain side during data reading.

A method for manufacturing the above described non-volatile memories will be explained hereinbelow. At the outset, a buffer oxide film is grown to a thickness of 1000Å on the P-type silicon substrate 101. Then on the buffer oxide film a 3000Å thick silicon nitride film is deposited which constitutes an antioxidant film. On the silicon nitride film, a photoresist pattern is formed which is open to a region where a device isolation oxide film is formed to isolate a device region into an island-like configuration. The selective removal of the silicon nitride film with this pattern as a mask results in the formation of a silicon nitride film pattern which is open at a portion where the device isolation oxide film is formed. Then, after the resist pattern is removed by etching, boron ions are implanted with the silicon nitride film pattern as a mask (an injection energy; 40KeV : a dose amount; $5 \times 10^{13}$ ions/cm$^2$ ) thereby forming a field dope layer. Thereafter, by wet oxidation at 1000°C a silicon oxide film is grown on an exposed surface of the P-type silicon substrate to form a device isolation oxide film 109. At this step, activation and redistribution of boron atoms in the field dope layer lead to the formation of a reverse prevention layer on the lower layer of the device isolation oxide film 109.

Then, the silicon nitride film pattern is removed with dry etching. The buffer oxide film is further removed with wet etching using ammonium fluoride. This is followed by thermal oxidation by which the second gate insulating film 102 is grown to a thickness of 20nm on the exposed surface of the P-type silicon substrate. Then the resist is coated on the entire surface of the substrate so that the photoresist pattern is formed with the photoetching method, the pattern being open in a region which provide a gate insulating film on the side of the source region. Part of the second gate insulating film 102 is removed with hydrofluoric acid with the resist pattern as a mask. After the photoresist pattern is removed, the first gate insulating film 103 is formed with thermal oxidation. At this step, the second gate insulating film 102 is additionally oxidized. Hence, the second gate insulating film 102 having a rather thick thickness is formed.

The thickness of the first gate insulating film 103 is controlled to a thickness on the order of 10nm in the same manner as the gate insulating film of a normal non-volatile memory. The thickness of the second gate insulating film 102 is set to 25 to 35nm. Then, polysilicon film is grown to a thickness of 1500 Å on the entire surface of the substrate by chemical vapor deposition (CVD). After N-type impurities such as phosphorus or the like are introduced by thermal oxidation or ion implantation, the polysilicon film is etched with the resist pattern to form a floating gate electrode 104. After the resist pattern is removed, the surface of the floating gate electrode 104 is oxidized to form a 20 to 30nm thick interlayer insulating film comprising a silicon oxide film. Subsequently, about 2500Å thick polysilicon film is formed on the entire surface of the substrate by CVD or the like . The polysilicon film is doped with phosphorus just as the floating gate electrode 104. After that, about 1500Å thick silicon oxide film is formed by, for example, the CVD.

Then the silicon oxide film and polysilicon film are etched with a mask comprising a resist film so that the silicon oxide film and the polysilicon film are consecutively patterned to form a control gate electrode 106. At this time, a portion of a floating gate electrode projecting from the lower portion of the control gate electrode 106 in the lengthwise direction of the channel is etched so that the floating gate electrode 104 and the control gate electrode 106 are formed in self-alignment. Then after the resist is removed, an oxide film is formed on the entire surface thereof, and arsenic (As) ions are implanted at a low energy using the control gate electrode 106 and the floating gate electrode 104 as a mask so that a low concentration diffusion layer is formed in a region where a source region is formed. Then after an oxide film is formed by gas phase growth by CVD, a CVD silicon oxide film is etched back by reactive ion etching (RIE) with the result that a side wall is formed on the side of the control gate electrode 106 and the floating gate electrode 104. As ions are implanted at implantation energy of 40KeV and in the dose amount of $5 \times 10^{15}$ ions/cm$^2$ using the control gate electrode 106, the floating gate electrode 104, and the side wall as a mask and then the substrate is oxidatively annealed so that a source and drain regions (107 and 108) are formed. Thereafter, an interlayer insulating film is formed in accordance with a normal process followed by providing a contact hole and performing a metallization to form a passivation film thereby completing a non-volatile memory having the most basic structure.

In this manner thinning the film on the source side of the gate insulating film below the floating gate electrode facilitates the generation of F-N tunneling in erasing operation. Besides, since the oxide film is thick on the drain side, errors in erasure from the drain side in reading out and writing data can be prevented.

Thus, the non-volatile memory exchanges very frequently electric charges through an extremely thin oxide film located below the floating gate electrode. Efficiency at which carriers are exchanged largely affects the heightening of the speed at which the device can operate. In addition, it is not too much to say that the endurance and the reliability of the non-volatile memory depends on how such a thin oxide film can be formed. However, the aforementioned conventional structure of the non-volatile memory and conventional method for manufacturing the non-volatile memory have the following drawbacks.

In other words, in accordance with the conventional structure of the non-volatile memory, since injected electric charges proceed in a direction almost completely parallel to the oxide film located below the floating gate electrode, and there arises a problem that an F-N tunneling is difficult to achieve.

Besides, in the manufacturing process, a process for forming a thin oxide film below the floating gate electrode comprises a plurality of steps such as:

(1) forming a first gate insulating film,
(2) coating a photoresist,
(3) exposing and patterning the photoresist,
(4) etching part of the first gate insulating film by using a photoresist pattern as a mask,
(5) peeling off the photoresist, and
(6) forming a second gate insulating film.

Therefore, it has been extremely difficult to form highly accurate and thin oxide thin film with good reproducibility. In addition, there exists a step at which the gate insulating film closely contacts an organic resist. Thus, it was difficult to prevent contamination of the gate insulating film. Moreover, the oxide film is additionally oxidized after the removal of part of the first gate insulating film so that an edge stress is likely to be generated on a silicon interface in the boundary region of the first gate insulating film and the second gate insulating film. Therefore, it was extremely difficult to secure a certain level of yield owing to the insulating breakdown of the oxide film before the endurance and reliability of the oxide film can attract the attention of manufacturers.

Furthermore, USP 4,964,080 and USP 5,049,515 describe non-volatile memories having a select gate structure in which a select gate electrode is formed so that the control gate electrode closely contacts a channel region (vertical region) via an insulating film. However, these non-volatile memories have a drawback of finding a difficulty of high integration compared with a non-volatile memory in which the control gate electrode and the floating gate electrode are formed in self-alignment.

US 4,878,101 (corresponding to the preamble of claim 1) relates to an EPROM cell having source, drain and channel regions, a floating gate electrode and a control gate electrode. The channel region is stepped so that it is on two levels.

GB-A-2 073 484 discloses an EPROM cell with an inclined channel portion.

## SUMMARY OF THE INVENTION

The present invention provides a non-volatile semiconductor memory as set out in claim 1.

## BRIEF DESCRIPTION OF THE DRAWINGS

The present invention will be detailed in conjunction with the accompanying drawings, but they are not intended to limit the scope of the present invention.

Fig. 1 is a schematic sectional view of a non-volatile memory of an embodiment of the present invention.

Fig. 2(a) to (e) is a schematic sectional view of the non-volatile memory of an embodiment of the present invention.

Fig. 3 is a view for illustrating an electric connection of the non-volatile memory of an embodiment of the present invention.

Fig. 4 is a view for illustrating an electric connection of the non-volatile memory of an embodiment of the present invention.

Fig. 5 is a view for illustrating an electric connection of the non-volatile memory of an embodiment of the present invention.

Fig. 6 is a schematic sectional view showing part of the process for manufacturing a non-volatile memory of an embodiment of the present invention.

Fig. 7 is a schematic sectional view showing part of the process for manufacturing a non-volatile memory of an embodiment of the present invention.

Fig. 8 is a schematic sectional view showing part of the process for manufacturing a non-volatile memory of an embodiment of the present invention.

Fig. 9 is a schematic sectional view showing part of the process for manufacturing a non-volatile memory of an embodiment of the present invention.

Fig. 10 is a schematic sectional view showing part of the process for manufacturing a non-volatile memory of an embodiment of the present invention.

Fig. 11 is a schematic sectional view showing part of the process for manufacturing a non-volatile memory of an embodiment of the present invention.

Fig. 12 is a schematic sectional view showing part of the process for manufacturing a non-volatile memory of an embodiment of the present invention.

Fig. 13 is a schematic sectional view showing part of the process for manufacturing a non-volatile memory of an embodiment of the present invention.

Fig. 14 is a schematic sectional view showing part of the process for manufacturing a non-volatile memory of an embodiment of the present invention.

Fig. 15 is a schematic sectional view showing part of the process for manufacturing a non-volatile memory of an embodiment of the present invention.

Fig. 16 is a schematic sectional view showing part of the process for manufacturing a non-volatile memory of an embodiment of the present invention.

Fig. 17 is a schematic sectional view showing part of the process for manufacturing a non-volatile memory of an embodiment of the present invention.

Fig. 18 is a schematic sectional view showing part of the process for manufacturing a non-volatile memory of an embodiment of the present invention.

Fig. 19 is a schematic sectional view showing part of the process for manufacturing a flash memory of an embodiment of the present invention.

Fig. 20 is a schematic sectional view showing part of the process for manufacturing a non-volatile memory of an embodiment of the present invention.

Fig. 21(a) to (c) is a schematic sectional view showing part of the process for manufacturing a non-volatile memory of an embodiment of the present invention.

Fig. 22(a) to (c) is a schematic sectional view showing part of the process for manufacturing a non-volatile memory of an embodiment of the present invention.

Fig. 23(a) to (c) is a schematic sectional view showing part of the process for manufacturing a non-volatile memory of an embodiment of the present invention.

Fig. 24(a) is a schematic sectional view of the non-volatile memory of an embodiment of the present invention.

Fig. 24(b) is an expanded view of the portion A in FIG. 24 (a).

Fig. 25 is a view further expanding the inclined portion of the channel region of the non-volatile memory in FIG. 24.

Fig. 26 is a schematic sectional view of the non-volatile memory of an embodiment of the present invention.

Fig. 27 is a schematic sectional view of the non-volatile memory of an embodiment of the present invention.

Fig. 28 is a schematic sectional view of a device in which the non-volatile memory of an embodiment of the present invention is used.

Fig. 29 is a schematic sectional view of the non-volatile memory of an embodiment of the present invention.

Fig. 30 is a schematic sectional view of the non-volatile memory of an embodiment of the present invention.

Fig. 31 is a schematic sectional view of the non-volatile memory of an embodiment of the present invention.

Fig. 32 is a wiring diagram in which the non-volatile memory of an embodiment of the present invention is arranged in matrix configuration.

Fig. 33 is a wiring diagram in which the non-volatile memory of an embodiment of the present invention is arranged in matrix configuration.

Fig. 34 is a schematic sectional view of a conventional non-volatile memory.

Fig. 35 is a schematic sectional view of a conventional non-volatile memory.

Fig. 36 is a schematic sectional view of a conventional non-volatile memory.

Fig. 37(a) to (b) is a schematic view showing the hot electron injection mechanism of the non-volatile memory of an embodiment of the present invention.

Fig. 38 is a schematic view showing the hot electron injection mechanism of the non-volatile memory of an embodiment of the present invention.

Fig. 39 is a plan view of the non-volatile memory shown in Fig. 1.

Fig. 40 is a schematic sectional view of the non-volatile memory of an embodiment of the present invention.

Fig. 41 is a schematic sectional view of a non-volatile memory of an embodiment of the present invention.

Fig. 42(a) to (c) is a schematic sectional view showing part of the process for manufacturing a non-volatile memory shown in Fig. 41.

Fig. 43(a) to (c) is a schematic sectional view showing part of the process for manufacturing a non-volatile memory shown in Fig. 41.

Fig. 44(a) to (c) is a schematic sectional view showing part of the process for manufacturing a non-volatile memory shown in Fig. 41.

Fig. 45(a) to (c) is a schematic sectional view showing part of the process for manufacturing a non-volatile memory shown in Fig. 41.

Fig. 46(a) to (c) is a schematic sectional view showing part of the process for manufacturing a non-volatile memory shown in Fig. 41.

## DESCRIPTION OF THE PREFERRED EMBODIMENTS

The inventors of the present invention have devised an electrically erasable and programmable memory (EEPROM) having a floating gate electrode, which memory can improve the endurance and reliability of the oxide film below the floating gate and improve the performance thereof as well as a method for manufacturing the same, and have made the present invention.

Furthermore, the present invention can improve the charge retention characteristic of the floating gate electrode.

A non-volatile memory according to an embodiment of the present invention can be used as a flash memory.

With respect to a semiconductor substrate for an embodiment of a non-volatile memory of the present invention, one that can be used in normal non-volatile memories can be used. Such semiconductor substrates include silicon substrate, GaAs substrate and the like. Furthermore, a semiconductor substrate can be used which contains either a p-type or an n-type impurity in advance. Such impurities include boron and the like as p-type impurities and phosphorus, arsenic, and the like as n-type impurities. Here the second conductive type is n-type if the first conductive type is p-type, and vice versa. Furthermore, a substrate is preferably used which is deprived of toxic impurities and defects by gettering. Additionally, an inclined portion is provided on the substrate. Preferably, the inclined portion has a height of 100 to 5000Å and a width of 200 to 8000Å (1 Å = 0.1 nm). The height can be adjusted so that resolution is not deteriorated in exposure. The height is preferably shorter.

The non-volatile memory of the present invention is characterized by the fact that on the surface layer of the substrate a source impurity diffusion region (hereafter referred to as "a source region" for short) and a drain impurity diffusion region (hereafter referred to as "a drain region" for short) are provided, and the source region is located relatively upper or lower than the drain region.

Furthermore, the semiconductor device provides a channel region between the source region and the drain region of the second conductive type. Incidentally, arranging the drain region up to the inclined portion allows formation of a device having a short channel. Impurities having a conductive type opposite to the substrate are implanted in the source region and the drain region. Preferably the impurity concentration is $10^{19}$ to $10^{21}$ ions/cm$^3$. Furthermore, a region having a higher impurity concentration than the bulk and the same conductive type can be provided in the neighborhood of the drain region. Providing such a region improves the efficiency of hot electron generation thereby raising the writing speed. The channel region can be formed to a sufficient depth which allows the semiconductor device to be free from an influence of profiles that is caused when another impurity region is formed. Preferably such depth assumes Rp 0.1 to 0.4µm.

Furthermore, on the substrate a floating gate electrode and a control gate electrode are laminated in this order in such a manner that the floating gate electrode and the control gate electrode stretch over the source region and the drain region. Between the substrate and the floating gate electrode, and between the floating gate electrode and the control gate electrode, a gate insulating film is arranged. As a material of each of the electrodes, known materials can be used which include polysilicon and the like. On the entire surface or portion of the floating gate electrode, the impurities concentration or the conductive type thereof can be varied by diffusion or ion implantation. Preferably, each thickness of the floating gate electrode and the control gate electrode is 3000 to 5000Å.

Furthermore, a known material can be used as a gate insulating film such as, for example, a film comprising silicon oxide, silicon nitride, tantalum or dielectric substance. The gate insulating film may be formed of silicon oxide film-silicon nitride film-silicon oxide film (ONO structure). Additionally, the gate insulating film is formed thinner by an interlayer film between the control gate electrode and the floating gate electrode so that substantially traps will not be generated. In other words after a dry $O_2$ oxidation, a nitriding process is applied under argon (Ar) and ammonia (NH$_3$) atmosphere at a temperature higher than 1000 °C for about 10 to 30 minutes. This reduces the amount of H$_2$O and OH radicals in the gate insulating film thereby reducing the traps. Here, preferably the insulating film between the substrate and the floating gate electrode is thinner on the side of the source region than on the side of the drain region. Forming the insulating film thinner on the side of the source region than on the side of the drain region facilitates the generation of Fowler-Nordheim tunneling on the side of the source region and improves the dielectric strength on the side of the drain region. Hereafter, the thinner gate insulating film on the side of the source region is referred to as a first gate insulating film whereas the thicker gate insulating film on the side of the drain region is referred to as a second gate insulating film. Preferably the thickness of the first gate insulating film and the second gate insulating film ranges between 70 to 100Å and 100 to 200Å respectively.

The thickness of a gate oxide film (the oxide film is hereafter referred to as a third gate insulating film) between the floating gate electrode and the control gate electrode ranges preferably between 150 to 300Å both inclusive. The third gate insulating film may be thin on the side of the drain region and thick on the side of the source region to improve the lead-in effect. For reducing leakage of electric charges, a SiN film may be used in one layer of the insulating film. This can prevent an erred erasure by internal photoemission or the like.

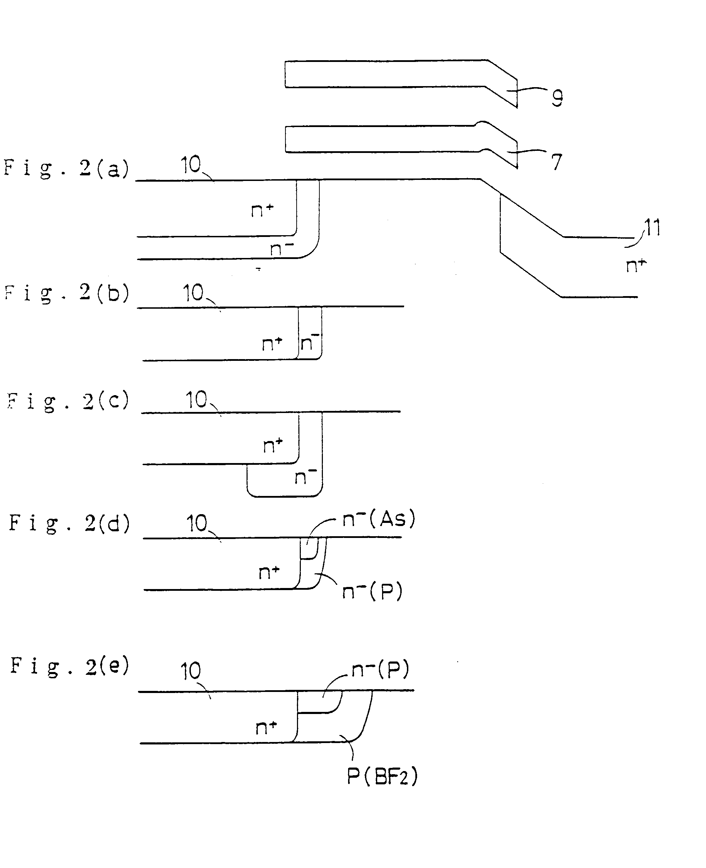

As shown in Fig. 2 (a)-(e), the source region may have an LDD structure, a DDD structure or a PLDD (Profiled Lightly Doped Drain) structure, a DI(Double Implanted)-LDD structure. Forming the above structure on the side of the source region widens the depletion layer and improves the dielectric strength. In order to heighten the electric field strength by steepening the concentration gradient of the junction in the drain region, the above structure is not formed on the side of the drain region. In LDD structure, a low concentration region of the second conductive type is further formed on the side of the channel region. Preferably, the impurity concentration in the LDD low concentration region ranges between $10^{17}$ to $10^{13}$ ions/cm$^3$ both inclusive. Alternatively, the low concentration region can be formed to cover a part of or all of the side end of the drain region or to cover partly the lower end of the source region (See Fig. 2 (b)-(c)).

In DDD structure, the low concentration region is formed so as to cover the source region. Preferably, the impurity concentration in the low concentration region is $10^{18}$ to $10^{19}$ ions/cm$^3$ (See Fig. 2 (a)). Incidentally, the DDD structure has an advantage that the punch-through is hardly generated compared with the LDD structure. Furthermore, with respect to the PLDD structure, an impurity region is formed in such a manner that the region covers the low concentration region of the LDD structure and the source region. Preferably, the impurity concentration in the PLDD low concentration region ranges between $10^{17}$ to $10^{19}$ ions/cm$^3$ both inclusive (See Fig. 2 (d)).

In DI-LDD structure, an impurity region of the first conductive type is formed on the side of the channel region and, moreover, a low concentration region of the second conductive type is formed on the surface layer of the impurity region adjacent to the source region (See Fig. 2 (e)). Preferably, the impurity concentration of the impurity region of the first conductive type is within the range of $10^{16}$ to $10^{18}$ ions/cm$^3$, and the impurity concentration of the low concentration region of the second conductive type is within the range of $10^{18}$ to $10^{20}$ ions/cm$^3$.

These structures serve to render the dielectric strength lower in the drain region than in the source region and to improve insulating strength in erasing operation. In addition, preferably, a damaged region formed in ion implantation (in a dose amount of 1 to 9 X $10^{14}$ ions/cm$^2$) may be diffused so that the region may not overlap due to ion implantation for the formation of the above low concentration region and the following source region. For example, a smooth side wall spacer may be extended over a side wall of the antioxidant film so that ions are implanted through the side wall spacer. This prevents the overlapping of the region damaged by the profile formed by ion implantation to the silicon immediately below the edge of the antioxidant film. This side wall spacer can be easily formed by anisotropic etching or using a two-layer film having a different etching rate.

Although the non-volatile memory in the above example takes a two-layer polysilicon structure, the non-volatile memory can take a three-layer polysilicon structure. For example, the non-volatile memory can include an erasing gate.

Furthermore, a device can be isolated with a gate electrode in place of using a device isolation oxide film. Still furthermore, an embedded diffusion layer (bit line or the like) may be provided under the device isolation oxide film.

A method for manufacturing a non-volatile memory according to an embodiment of the present invention will be detailed hereinbelow.

**Pretreatment for Forming the Device Isolation Oxide Film**

At the outset, on a semiconductor substrate having a predetermined conductive type, a buffer oxide film having a thickness of 1000Å or more is formed by thermal oxidation. This buffer oxide film is formed for obtaining a length of a bird's beak having a good reproducibility, suppressing the generation of the translocation and slippage in the silicon substrate in this region, and alleviating the stress applied to the antioxidant film to be formed in the subsequent process. The shape of the inclined region and the crystal state in the region inside the silicon substrate where hot electrons are generated depend on the quality and the thickness of this buffer oxide film. Therefore, the quality and the thickness of the buffer oxide film are empirically conditioned and determined so as to adjust the total process to the device operation. On the buffer oxide film, for example, a photoresist is applied so that a pattern is formed in which only a region for device isolation is open.

Subsequently, for forming a channel dope layer, impurities are implanted into the semiconductor substrate. The impurities to be implanted may be boron or the like as a P-type impurity, and phosphorus or the like as an n-type impurity. The impurity implantation may be conditioned as follows: preferably, the dose amount is $10^{12}$ to $10^{13}$ ions/cm$^2$ and implantation energy 40 to 200KeV since impurity ions have to be implanted to a sufficient depth so that the substrate might not be affected by the tail of the ion implantation profile. The dose amount and the implantation energy are very important because the hot electron injection efficiency depends on the concentration.

The subsequent process is to remove the resist, followed by forming an antioxidant film having a thickness of 700 to 1000Å by the CVD or the like. Preferably, a silicon nitride film is used as the antioxidant film. This is followed by selectively removing the antioxidant film, by etching using the photoresist, from the portion where a device isolation region is to be formed.

The resist is removed, and a spin on glass (SOG) film, a TEOS (Si(OC$_2$H$_5$)$_4$) film, PCVD·TEOS/SOG/PCVD·TEOS film or the like is laminated on the substrate by coating, PCVD method, or the like, which is followed by forming a side wall spacer on the side wall of the antioxidant film. The PCVD·TEOS film can be formed out of Si(OC$_2$H$_5$)$_4$ and O$_2$. Then, for forming a field dope layer, impurities are implanted by an implantation energy of 100 to 150KeV and in a dose amount of $10^{13}$ to $10^{14}$ ions/cm$^2$. Known materials can be used as impurities. In addition, the side wall spacer restricts the implantation of impurities. Thus, the field dope layer can be formed only in a predetermined region.

**Process for Forming the Device Isolation Oxide Film**

At the subsequent step the device isolation oxide film is formed by thermal oxidation (LOCOS method as it is called) at 1000 to 1100°C or CVD method or the like. The formation of the device isolation oxide film activates and redistributes the above field dope layer to an inversion prevention layer at the lower layer of the device isolation oxide film. At the corner edge portion of the device isolation oxide film, a layout is designed so that the main portion of the device might not be located therein.

**Step of Forming An Active Region**

Subsequently, part of the device isolation oxide film is removed by an anisotropic etching method such as RIE using a resist mask. Further, anisotropic etching is replaced by isotropic etching using hydrofluoric acid or the like, and the device isolation oxide film under the antioxidant film is etched to a prescribed amount. Then SOG film is coated on the entire surface to a film thickness of 4000 to 8000Å. This film may be treated with an etch back process if necessary.

Next, the antioxidant film is removed by etching with hydrofluoric acid or the like, thereby lifting off the SOG film formed on the antioxidant film. Subsequently, the buffer oxide film and the oxide film at the end of the device isolation oxide film are removed. A known method can be applied to the removal, but the use of an etchant that affects the silicon interface is not preferable. Nor dry etching appropriate. Preferably, wet etching using HF, for example, can be applied.

In this manner, the inclined portion formed by oxidation assumes a smooth configuration as compared with the inclination formed by etching. As a consequence, the stepped portion can be more favorably coated, which allows reducing stress on a floating gate electrode or the like which will be formed in the subsequent step, thereby improving the reliability of a device that will be miniaturized. Additionally, the oxidation has an advantage that it causes smaller damage to the silicon interface than etching thereby allowing manufacturing a stable device. In addition, the length of the bird's beak that affects the size of the inclined portion can be easily controlled by controlling the thickness of the buffer oxide film. Then, the minute measurement of the buffer oxide film can be easily adjusted.

**Step of Forming the First and the Second Gate Insulating Film**

At the subsequent step, a resist or the like is removed to form the first and the second gate insulating film. When the oxide film is used as the insulating film, the insulating film can be formed by thermal oxidation. The method for oxidation can be determined in consideration of the kind of device and the alignment between processes. The method for oxidation include, for example, oxidation using dry $O_2$, pyrogeneratic oxidation and the like. The oxidation temperature may be relatively low ranging between 850 and 950°C. Preferably, the oxidation is performed at about 900°C (in the oxidation at 900°C, since boron impurities are diffused, the resulting device has an inner channel structure). That is because the oxide film formed by using the dry $O_2$ (the pyrogeneratic oxidation may be used to reduce the trap level) has many advantages such as the largest activated energy which allows easy control of the oxide film, excellent dielectric strength properties, no shift in the threshold value and no increase in the trap density in the oxide film. Such oxidation oxidizes exposed substrate with the result that the thickness of the oxide film of the inclined portion at a portion where the device isolation oxide film is removed becomes thicker than the thickness of the oxide film at the portion of the buffer oxide film. Here, the insulating film at the inclined portion serves as the second gate insulating film whereas the insulating film at the buffer oxide film portion serves as the first gate insulating film. In this way, insulating films having different thicknesses can be formed by one oxidation process.

Otherwise, an inactive substance which can further thermal oxidation, such as argon or the like, can be preliminarily implanted to a region where the first gate insulating film is formed either with or in combination with the aforementioned impurity implantation. Still otherwise, Si ions may be implanted to a region where the first gate insulating film is formed so that the bonding force of Si crystal can be weakened. Such Si ion implantation is advantageous in suppressing diffusion of impurities into the substrate in the buffer oxide film. Incidentally, after the formation of the insulating film, the substrate can be subjected to annealing in the atmosphere of $H_2$ for adjusting the impurity concentration in the insulating film. Since the substrate is oxidized at relatively low temperature, high interface fixing electric charges are generated in the insulating film. The high electric charges can be reduced by subjecting the substrate to annealing in the inactive atmosphere of $N_2$, Ar or the like. In addition, when the region where the first and the second gate insulating films are formed are subjected to sacrificial oxidation before the formation of the first and the second gate insulating films, more favorable insulating films can be formed.

**Step of Forming A Floating Gate Electrode**

At the subsequent step, polysilicon or the like is laminated on the entire surface of the substrate by CVD or the like followed by etching to form a floating gate electrode at a desired position of the substrate. As an implantation film, an HTO film and a second laminate layer obtained by thermal oxidation of the HTO film can be used.

**Step of Forming a Source and Drain Regions**

At the subsequent step, after the removal of the SOG film by a known etching method, a source and a drain region are formed with the floating gate electrode serving as a mask by impurity implantation. Preferably, conditions for impurity implantation can be an implantation energy of 30 to 80KeV, a dose amount of $10^{15}$ to $10^{16}$ ions/cm$^2$. The amount of n$^+$ implantation into the floating gate electrode is so conditioned as to adjust the interface potential barrier between the polysilicon and the implanted oxide film according to the area of the oxide film into which electric charges are injected. The design-rule for the sheet resistivity and the like of the source region and the drain region is coordinated with the adjustment of the above interface potential barrier. At this implantation, the source region is formed through the intermediary of the gate insulating film, and therefore is shallower than the drain region. Here, a deeper channel region can be formed by implanting Si ions to the inclined portion of the channel region through the floating gate electrode.

## Step of Forming a Third Gate Insulating Film

At the subsequent step, a third gate insulating film is formed by subjecting the floating gate electrode to oxidation or by other methods.

## Step of Forming a Control Gate Electrode

A control gate electrode is formed by laminating polysilicon or the like on the entire surface of the third gate insulating film, followed by etching the polysilicon or the like to form a control gate electrode. Furthermore, the entire surface on the substrate is subjected to oxidation to form an oxide film thereon. Subsequently by using a resist or the like, a side wall spacer is formed on the side wall of the control gate electrode facing the source region, and then the floating gate electrode is subjected to side-etching by isotropic etching, thereby controlling the overlapping part of the control gate electrode and the floating gate electrode.

## At the Subsequent Steps

At the subsequent steps, in accordance with the normal process, an interlayer insulating film is laminated, a contact hole is opened, and a passivation film is formed by metallization which allows forming a non-volatile memory having a self-alignment structure. A PCVD·TEOS/SOG/PCVD·TEOS film can be used for the interlayer insulating film. Moreover, the adhesion between the SOG film and the PCVD·TEOS film can be improved by hitting with $O_2$ plasma the surface of the SOG film before depositing the PCVD·TEOS film on the SOG film.

## When LDD Structure is Formed

An LDD structure can be formed by etching the floating gate electrode and the control gate electrode in self-alignment and then masking the drain region with a resist or the like, followed by implanting impurities with an oblique rotation implantation method (implantation angle from 50 to 70°). Preferably, the implantation conditions can be an implantation energy of 40 to 80KeV and a dose amount of $10^{14}$ to $10^{16}$ions/cm$^2$.

## When DDD Structure is Formed

A DDD structure can be formed by ion implantation of a high concentration of $^{75}As^+$ after ion implantation of a low concentration of $^{31}P^+$. Preferably, the implantation condition of $^{75}As^+$is an implantation energy of 30 to 80KeV and a dose amount of $10^{14}$ to $10^{16}$ ions/cm$^2$.

## When PLDD Structure is Formed

A PLDD structure can be formed by gradually changing an implantation angle and an implantation energy. Preferably, the implantation conditions can be an implantation energy of 20 to 100KeV, an implantation angle of 30 to 70° and a dose amount of $10^{13}$ to $10^{16}$ ions/cm$^2$. Besides, the implantation conditions may preferably be divided so that a peak concentration of the ion implantation profile assumes about $10^{19}$ to $10^{21}$ ions/cm$^2$. Besides, what is important here is to set a sufficient cooling -off period between implantations. For example, As ions may be implanted at an implantation energy of 80KeV and a dose amount of 2 X $10^{15}$ ions/cm$^2$, an implantation energy of 40KeV and a dose amount of 1.5 X $10^{15}$ ions/cm$^2$ and an implantation energy of 20KeV and a dose amount of 7 X $10^{14}$ ions/cm$^2$.

## When DI-LDD Structure is Formed

A DI-LDD structure can be formed by ion implantation of phosphorus or the like into the semiconductor substrate with the floating gate electrode as a mask, at an implantation energy of 20 to 60 KeV, and a dose amount of $10^{12}$ to $10^{14}$ ions/cm$^2$. Subsequently, an oxide film is formed on the entire surface, and then the oxide film is etched back by a reactive ion etching (RIE) process to form side wall spacers on both sides of the gate insulating film and the floating gate electrode. With the side wall spacers and the floating gate electrode as a mask, arsenic or the like is implanted into the substrate at an implantation energy of 20 to 60 KeV, and a dose amount of $10^{14}$ to $10^{16}$ ions/cm$^2$. Subsequently, an SiN layer with thickness about 5000Å is formed by a chemical vapor deposition (CVD) process. Then the SiN layer is flattened by coating a resist on the SiN layer. Further, the surface from the gate electrode toward the drain region is masked, and then the SiN layer and the resist are etched back by etching the SiN layer and the resist with equal etching rate until the surface of the gate electrode is exposed. Then the SiN layer is selectively etched by wet etching or the like until the upper portion (about the ratio of 3/8) of the side wall spacer is exposed. Next, with the above SiN layer on the active region kept as it is, the side wall spacer is selectively removed so that the portion of the semiconductor substrate is exposed. And using the gate electrode and the SiN layer as a mask, boron or the like is implanted into the above exposed portion at an implantation energy of 70 to 100 KeV, and a dose amount of $10^{12}$ to $10^{14}$ ions/cm$^2$, to form a DI-LDD structure.

Further the rotation ion implantation process as described in Japanese Unexamined Patent Publication No. HEI 5 (1993)-90519 can be used as well as the above process. In other words a DI-LDD structure can be formed by ion implantation at an angle of 30° to 60° and at predetermined implantation energy and a dose amount.

Incidentally, in the above description of the method for forming a non-volatile memory according to an embodiment of the present invention, a process has been proposed in which the gate insulating film depends on the dose amount of the substrate. However, the method in accordance with the present invention is not so limited. The non-volatile memory of the present invention can be manufactured using a conventional method. When a conventional method is used for manufacturing the non-volatile memory of the present invention, further cleaning and automation processes as well as extremely severe process control will be necessary.

For example, since the low concentration impurity diffusion layer 12 according to the manufacturing method of an embodiment of the present invention is formed by rotation (inclined) ion implantation, the concentration of the part that overlaps with the floating gate electrode lacked uniformity, and it was extremely difficult to control the area as desired. Besides, high energy ions irradiate the sides of the floating gate electrode and the gate insulating film immediately thereunder, causing problems such as decrease in insulating strength or instability in erasing operations by Fowler-Nordheim tunneling effect. In order to cope with these problems, the low concentration impurity diffusion layer 12 is formed before the gate insulating film is formed.

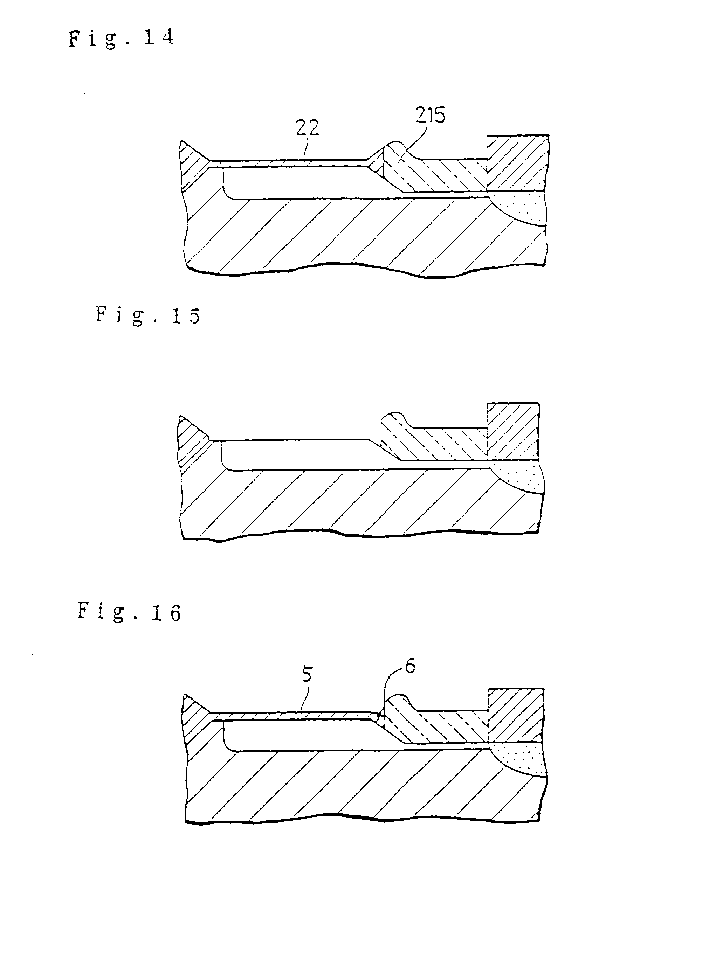

Namely, as shown in Figs. 21 (a) through (c), Figs. 22 (a) through (c),and Figs. 23 (a) through (c), after the surface of the substrate is exposed at the step of FIG. 15, the exposed surface is thermally oxidized to form a sacrificial oxide film 13 (which also serves as an oxide film formed before implantation) with thickness about 300Å. (See FIG. 21 (a).)

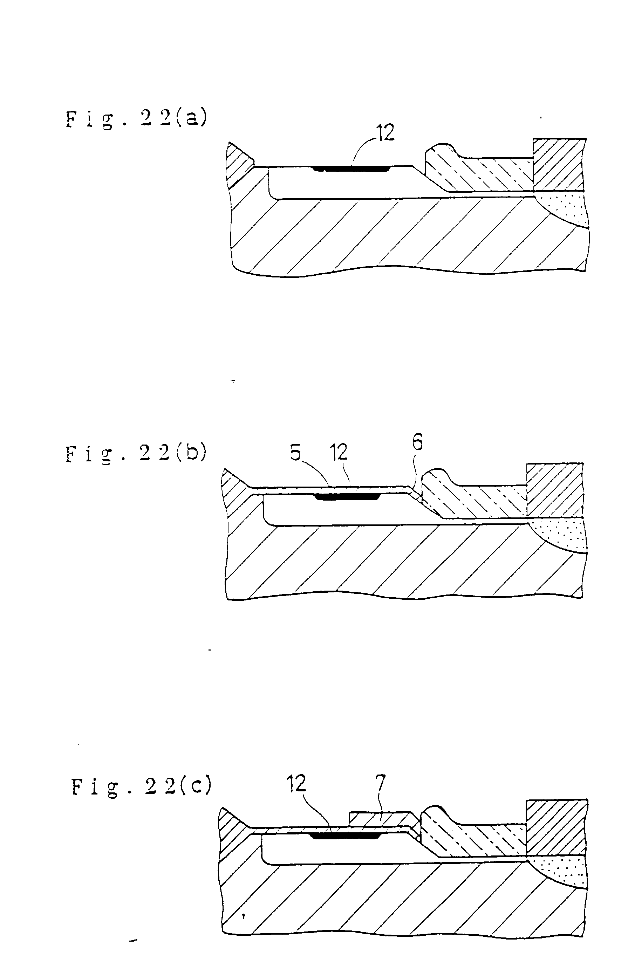

Then, a photoresist pattern 14 is formed as a mask for forming an LDD region. (See Fig.21 (b).) Next, using the above photoresist pattern 14 as a mask, ions such as arsenic are implanted to form a low concentration impurity diffusion region. (See FIG. 21 (c).) Further, the photoresist pattern 14 and the sacrificial oxide film are removed by etching. (See FIG. 22 (a).) Next, a gate insulating film is formed (See FIG. 22 (b).), and the floating gate electrode 7 is formed by etching so that the edge thereof on the source region side suitably defines the region where the high concentration source region is to be formed. (See FIG. 22(c).)

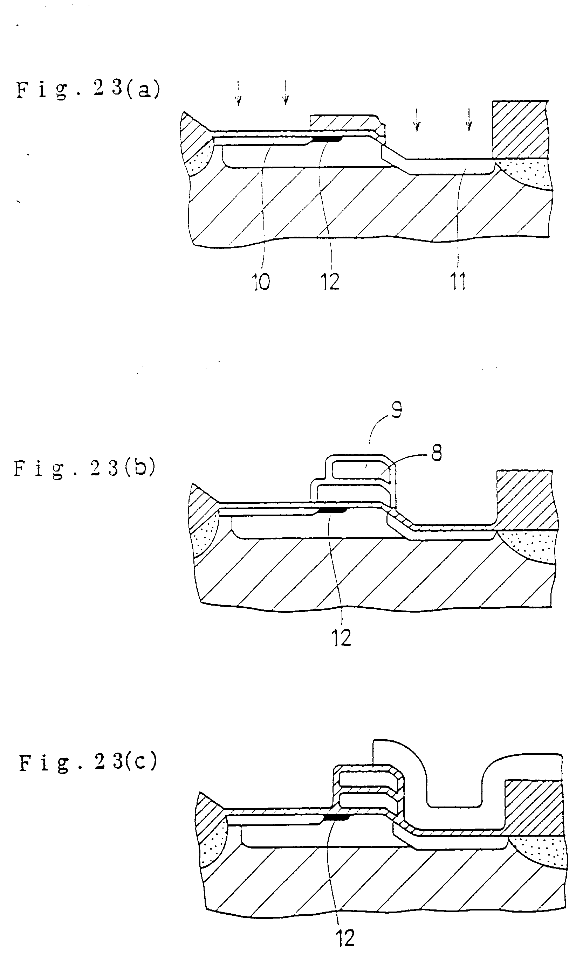

Subsequently, the SOG is removed and ions are implanted to form the source region and a drain region. (See FIG. 23 (a).) Further, a control gate electrode is formed . Here, the location of the edge of the control gate electrode on the source region side is decided so that the edge exactly determines the overlapping area of the low concentration impurity diffusion layer 12 and the floating gate electrode 7. (See FIG. 23 (b).) With this process, the overlapping area of the low concentration impurity diffusion layer 12 and the floating gate electrode 7 is determined . Here, the overlap can be about 0.2 $\mu$m under the floating gate electrode 7. (See FIG. 23 (c).) In this disclosure, the coupling ratio [C4/(C4+C3+C2+C1+C5)] was set, for example, between 0.5 and 0.8. Determining the value of C4 is followed by determining the capacitance of the above overlapping part.

Additionally, since the present invention does not use an offset gate, a bulk may be used in which a channel dope layer is formed to form with good accuracy a gate insulating film for erasing.

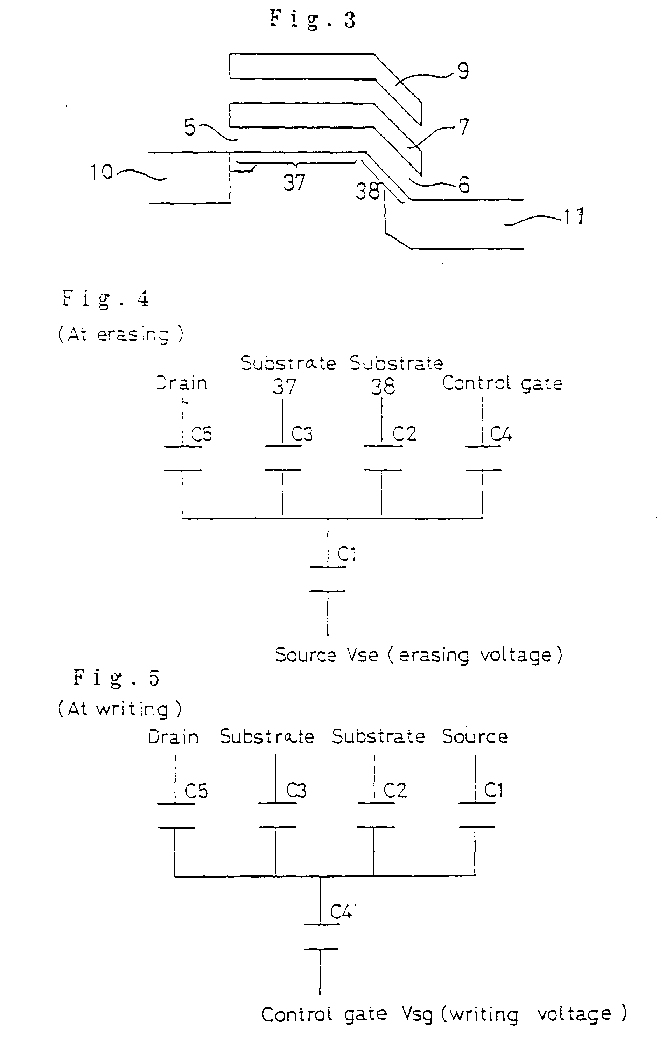

Referring to Figs. 3 to 5, an electric connection of the non-volatile memory according to the present invention will be explained hereinbelow.

Here symbol $V_{se}$ designates an erasing voltage applied to the source region 10, Vfg an electric potential at the floating gate electrode 7, C4 a parasitic capacitance between the control gate electrode 9 and the floating gate electrode 7, C3 a capacitance between the floating gate electrode 7 and the substrate 37, C2 a capacitance between the floating gate 7 and the substrate 38, and C1 a capacitance between the floating gate electrode 7 and the drain region 11.

When the thickness of the first gate insulating film 5 is designated by d1, the electric field Ee (erasing) applied to the inside of the first gate insulating film 5 can be briefly represented by the following equation (1):

$$E_e = V_{se} (C5 + C4 + C3 + C2)/d1 (C1 + C2 + C3 + C4 + C5) \qquad \text{Equation (1)}$$

Erasing memory by using a tunnel effect requires controlling the appropriate thickness d2. This result in an extreme increase in C1 and reduction in $E_e$ in the absence of the control of an area between the first insulating film 5 and the source region 10. Consequently, the present invention provides a simple method for manufacturing a non-volatile memory, which method allows selecting optimal capacitances described above and securing a definite level of yield ratio to obtain a desired $E_e$.

On the other hand, when the thickness of the second gate insulating film 6 at the pinch-off point is represented by d2, the writing voltage to the control gate electrode 9 by $V_{gw}$, the voltage $V_{fg}$ of the floating gate electrode 7 that contributes to the drawing of the hot carriers in the second insulating film can be represented by equation (2):

$$V_{fg} = V_{gw} (C4/(C4 + C2 + C3 + C5 + C1)) \qquad \text{Equation (2)}$$

Thus, the present invention allows appropriately setting properties of each region for producing C1 to C4, such as an area, a thickness and quality of films and eliminating the non-uniformity in the manufacture of non-volatile memories. Consequently, when memories become finer, writing and erasing properties can be maintained.

On the other hand, since C2 is formed by the substrate 38, the second gate insulating film 6 and the floating gate electrode 7, an effect can be alleviated which is produced as a result of the enlargement of C1 which results from enlarging the capacitance of C2 in equation (1).

Further, the inventors of the present invention have found out the following problems in the non-volatile memory having an inclined channel region. That is to say, since the floating gate electrode is formed by photo-lithography, alignment margin needs to be considered. Therefore, there were problems in a non-volatile memory having an inclined channel region such that it was difficult to suitably position the floating gate electrode with respect to the inclined part, thereby making it difficult to diminish the area of the memory device.

Moreover, in the above non-volatile memory having an inclined channel region, the control gate electrode is formed above the inclined floating gate electrode, so that it was difficult to form a control gate electrode while adjusting the overlapping area of the floating gate electrode and the control gate electrode with good reproducibility. This means that it was difficult to control the coupling capacitance between the control gate electrode and the floating gate electrode and the capacitance between the source region and the floating gate electrode to a desirable extent.

Therefore, the inventors of the present invention have found out a non-volatile memory structure of an inclined channel type, and a method for manufacturing the same, in which it is possible to diminish the size of memory cells.

Further, the inventors have found a non-volatile memory in which the capacity coupling ratio of the control gate electrode and the floating gate electrode can be kept constant even if the floating gate electrode is formed above the channel region having an inclined part.

The above non-volatile memory and the method for manufacturing the same will be explained as follows.

The manufacturing method as described earlier can also be applied here until the process of determining the end position of the floating gate electrode facing the drain region.

Incidentally, the side wall spacer used for forming the field dope layer may or may not be formed. Even when the field dope layer is formed in the active region, the field dope layer does not come close to the vicinity of the channel region in the non-volatile memory having such a fine floating gate electrode. Accordingly, even if the side wall spacer is not formed, the concentration of the impurity ions derived from the field dope layer which are present in the active region is low and the source and drain regions are counterdoped with impurity ions completely at a high concentration. Therefore, the process for forming the side wall spacer can be omitted.

The conductive type of the impurity ions for forming the field dope layer is the opposite of that for forming the drain region. Therefore, when the depth of the field dope layer and the junction depth of the drain region are aligned, the expansion of the depletion layer in the drain region can be controlled. As the result, an electric field may be integrated in the channel region, so that generation of the hot carriers at the pinch-off point may be facilitated.

After defining the position of the side end of the drain region of the floating gate electrode, a silicon nitride film and the like may be deposited on the whole surface to a thickness of 4000 to 8000Å by the PCVD method. Forming a thin preliminary oxide film on the surface of the substrate before depositing the silicon nitride film can alleviate the stress in the silicon nitride film. However, a thick preliminary oxide film is not preferable because it causes the thickness of the gate insulating film to be uneven on its end part closer to the drain region. Then, the device isolation region and the opening present in the device isolation region are masked with a photoresist and the like, and the silicon nitride film is removed.

After removing the mask, impurity ions are implanted to the substrate located under the edge of the device isolation oxide film to give an inclination of the impurity ion concentration in the inclined channel region. The concentration increases from the source region to the pinch-off point. It is preferable to use impurity ions having a small diffusion coefficient such as a boron ion.

Subsequently, the first and the second gate insulating films are formed in the same manner as described above. Then, polycrystal silicon and the like may be formed on the whole surface by the CVD method and the like, and an SOG film is coated such that the polycrystal silicon present in the step portion formed with the silicon nitride film is exposed. After removing the exposed polycrystal silicon, a flat film is formed by repeating an etching back of a film having a good step coverage such as the CVD silicon oxide film more than one time.

Next, the anisotropic etching which terminates at the point of time when the polycrystal silicon film is exposed is conducted. The film having a good step coverage remains on the polycrystal silicon. The polycrystal silicon is etched by the reactive anisotropic etching by using the film as a mask to form the floating gate electrode. The etchant used for the reactive anisotropic etching is preferably an etchant capable of selectively etching the polycrystal silicon and silicon oxide. Examples of the etchants include hydrogen bromide.

Subsequently, impurity ions are implanted by using the floating gate electrode and the silicon nitride film formed by the PCVD method as a mask under the same implantation condition as described for forming the LDD structure. It is preferable to use impurity ions with a high diffusion coefficient. This is due to the fact that at the following step of oxidizing the floating gate electrode, the floating gate electrode is shifted in a direction of the channel region and the shift amount needs to be considered. Namely, if the source region is formed with As (arsenic), for example, it is preferable to form the LDD structure with P (phosphorus). The area of the region where the F-N tunneling takes place is determined by the correlation between the amount of impurity ions in the LDD structure diffused in a horizontal direction (parallel to the channel region) at the end of the total process and the shift amount of the floating gate electrode in a direction of the channel region caused by oxidation of the side wall of the floating gate electrode.

After removing the silicon nitride film by the PCVD method and the like, the whole surface is oxidized to form an interlayer insulating film by a known method. Then, impurity ions are implanted by using the floating gate electrode as a mask to form the source and drain regions under the same implantation condition as described above. The source and drain regions having the more stable properties may be formed by a method disclosed in U.S. Patent No.5,238,858 in which impurities are implanted stepwise.

Then, a nitride film is formed on the whole surface of the substrate and the isotropic and anisotropic etchings are conducted to form the side wall spacer made of nitride film on the side wall of the floating gate electrode for preventing oxidation. The whole surface of the substrate is oxidized to form the floating gate electrode having the thick interlayer insulating film thereon with a thickness of 1000 to 3000Å. The capacity coupling between the side wall of the floating gate electrode closer to the drain region and the control gate electrode can exert a dominant power when the thickness of the thick interlayer insulating film is appropriately adjusted. Besides, the conditions for the thermal oxidation of the floating gate electrode determine the shift amount by which the side wall of the floating gate electrode closer to the source region is shifted in a direction of the channel region. Moreover, these thermal oxidation conditions affect the diffusion amount of the LDD structure in a horizontal direction (parallel to the channel region). The step-coverage of the wordline later formed will be improved as thickness of the thick interlayer insulating film gets thicker and thicker. However, if it is too thick, the width of the floating gate electrode along the channel region decreases, so that the processing conditions need to be determined carefully in view of the design rule.

The thick interlayer insulating film may be formed by oxidizing the whole surface of the substrate before removing the silicon nitride film by the PCVD method to simplify the manufacturing process.

Since the interlayer insulating film formed as above includes the thick insulating film at the source region side of the floating gate electrode, the source region and the floating gate electrode may be sufficiently separated, thereby improving the dielectric strength of the non-volatile memory.

Next, after removing the nitride film side wall spacer, the thin oxide film on the side wall of the floating gate electrode is removed. Then, the interlayer insulating film having a desired thickness is formed by a thermal oxidation and the like. The reliability of the interlayer insulating film may be improved by a sacrificial oxidation of the side wall of the floating gate electrode.

Subsequently, the polysilicon is deposited on the whole surface by a known method to form a control gate electrode having a desired shape. The control gate electrode may be formed as follows. The following method is preferable for improving the step coverage of the control gate electrode and making the capacitance coupling of the control gate electrode and the floating gate electrode more certain. First, polysilicon is deposited on the whole surface and a side wall spacer is formed on the side wall of the floating gate electrode by using the isotropic and anisotropic etchings. Then, the oxide film formed on the side wall spacer is removed and successively the polysilicon is deposited in-situ, thereby electrically connecting the control gate electrode with the side wall spacer.

Further, in order to reduce the sheet resistance of the polysilicon of the control gate electrode, impurity ions may be implanted into the control gate electrode and a metal silicide having a high melting point may be formed on the control gate electrode. In this case, impurity ions may be implanted at 20 ReV in a dose amount of $5 \times 10^{15}$ to $8 \times$

$10^{15}$/cm$^2$. The ratio of the metal having a high melting point to silicon in the silicide is preferably 1:3.

Examples of the metals include W and Ti.

After that, the non-volatile memory may be formed by the same method as described above.

The present invention can provide a non-volatile memory having a substantially long channel, a small area, a high writing and erasing speed, preventing mis-erasure in reading, excellent in mass production and size reduction, and having outstanding durability in frequent writing/erasing and reading operations.

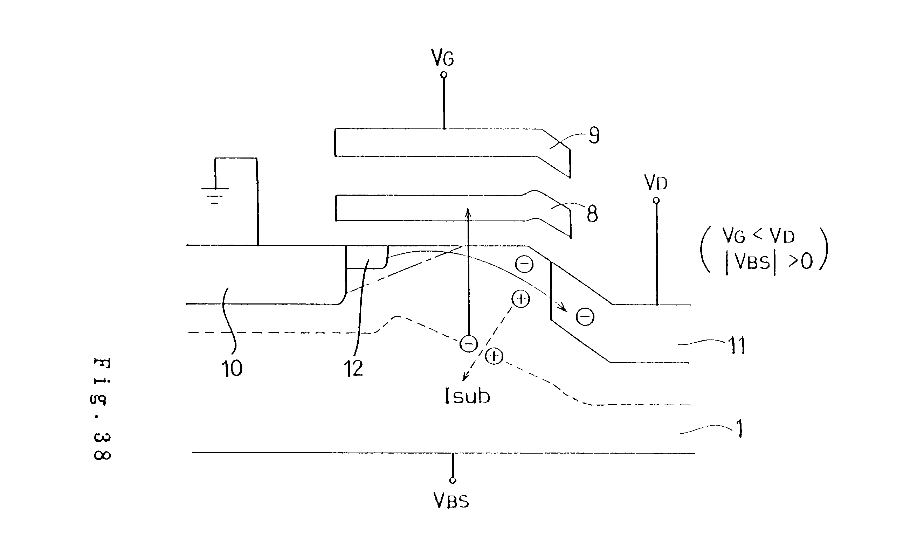

Incidentally, the present invention is described in detail using a Drain Avalanche Hot Carrier Injection theory shown in Fig. 37 (a) as a hot electron injection mechanism, but it is not clear what kind of injection theory can be applied to a device having an inclined part in the channel such as the one according to the present invention. Hot electrons are injected according to, for example, the Substrate Hot Electron Injection (Fig. 37(b)) mechanism or Secondary Impact Ionization Hot Electron Injection (Fig. 38) mechanism. It goes without saying that a different injection mechanism can be applied to unification of power supplies and reduction of bias voltage.

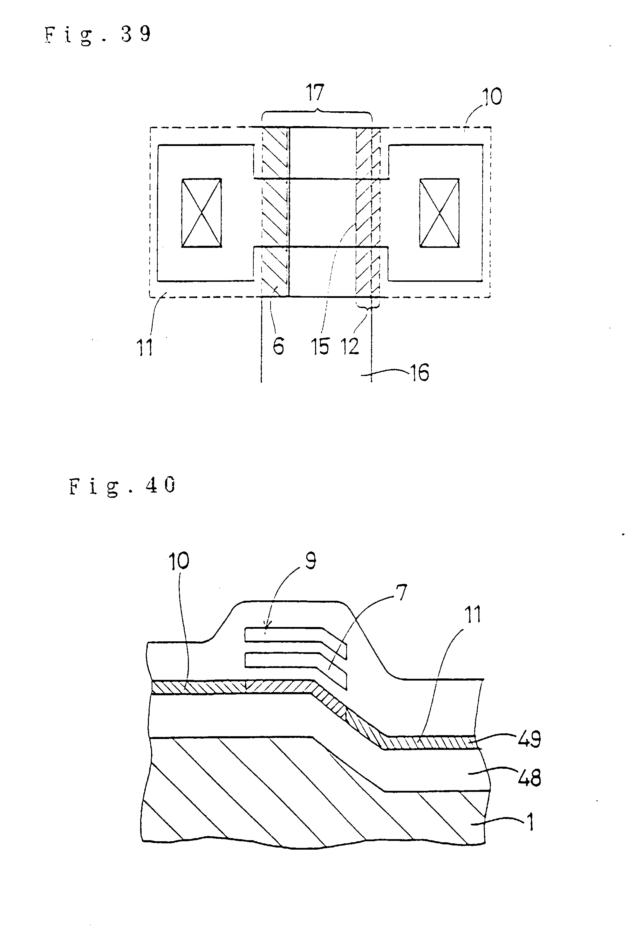

According to the manufacturing method of the present invention, the gate insulating film is not damaged during the formation of the low concentration impurity diffusion region, so that the dielectric strength is not reduced. With respect to the plan view of a memory cell according to an embodiment of the present invention shown in Fig. 39, the area of the source region can be reduced owing to the absence of a double diffusion process in forming the source region.

According to a non-volatile memory of an embodiment of the present invention having the floating gate electrode on the inclined portion of the channel region and a method for manufacturing the same, a floating gate which was conventionally formed by photoetching can be formed with RIE by etching polysilicon on the inclined region formed by removal of the bird's beak portion at the end of LOCOS, using the selectively formed insulating film as a mask, thereby reducing cell area compared with the conventional non-volatile memory. Besides, with respect to the operation of the non-volatile memory of the present invention, writing efficiency can be improved by adjusting the ion implantation energy of the impurity doped in channel region so that $R_p$ (implantation depth) is at the pinch-off point in writing operations.

Since the capacity coupling ratio between the control gate electrode and the inclined floating gate electrode is determined mostly by the capacity coupling area between the side wall of the floating gate and the control gate, the area can be retained so as to have a constant value by controlling the thickness of the floating gate electrode and the width of the channel region. Therefore, substantially, the capacity coupling ratio between the floating gate electrode and the control gate electrode does not change even if the floating gate electrode is inclined.

**EXAMPLES**

The present invention will be detailed with respect to examples hereinbelow, but the invention is not so limited. Modifications can be made based on each technological concept described above.

**Example 1**

A flash memory and a method for manufacturing the same will be explained in conjunction with the drawings when the flash memory is applied to a self-aligned flash memory cell transistor.

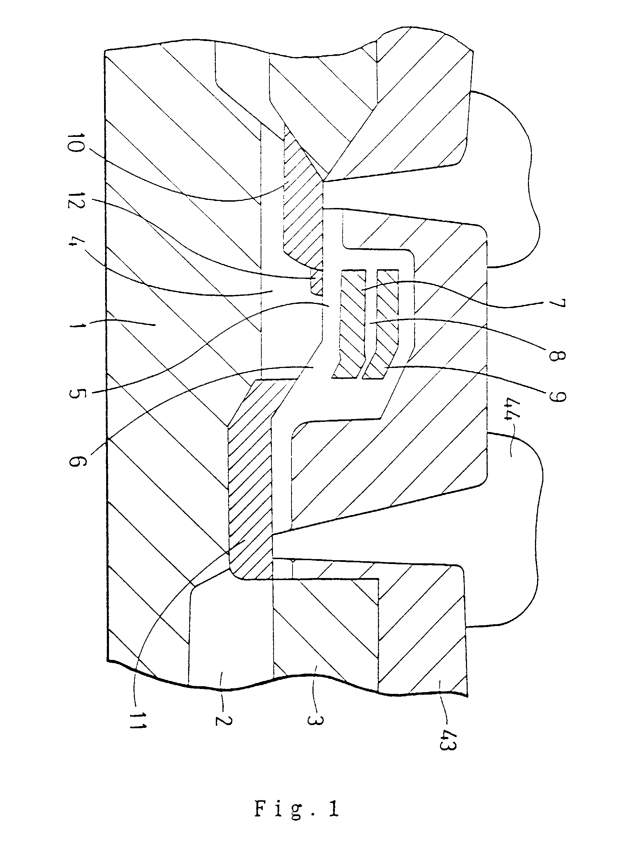

FIG. 1 shows a view showing a structure of a cross section of a single cell in a flash memory according to an embodiment of the present invention. Referring to FIG. 1, reference numeral 1 designates a P-type semiconductor substrate, 2 a field dope layer, 3 a device isolation oxide film (LOCOS), 4 a channel region, 5 a first gate insulating film, 6 a second insulating film provided on the inclined portion and formed from the channel region 4, 7 a first polysilicon layer (floating gate electrode), 8 a third gate insulating film, 9 a second polysilicon layer (control gate electrode), 10 a source region (N$^+$type impurity region), 11 a drain region (N$^+$type impurity region) and 12 an LDD region for improving the dielectric strength in the operation of erasing data in the memory.

The operation principle of the flash memory according to Example 1 is the same as the prior art. However, the feature of Example 1 of the flash memory is that the second gate insulating film 6 is formed in the inclined portion of the bird's beak length (about 0.6 - 0.8μm) formed from the bird's beak of the device isolation oxide film. Besides, the second gate insulating film 6 is characterized by being formed on the channel dope layer region 4 predetermined and controlled with high accuracy in the silicon substrate 1.

In other words, data is written in the flash memory by the application of a high voltage to the drain region 11 and the control gate electrode 9 followed by the absorption of the resulting hot carriers into the control gate electrode 9 and the subsequent accumulation of the hot carriers in the floating gate electrode 7. On the other hand, data is erased by the application of a high voltage to the source region with the control gate electrode 9 grounded (or negative bias), followed by the discharge of the accumulated electric charges in the floating gate electrode 7 using the F-N tunnel injection. The electric charge is discharged at this time through the thin first gate insulating film 5. Additionally, the drain region 11 is formed in a region where, originally, a device isolation oxide film is formed. Thus, the carrier electric charge takes a form of heading from the upper part of the drain region 11 to the lower part thereof. In this manner, the carrier electric charge progresses with a definite angle relative to the second gate insulating film 6.

Consequently, electric charges tend to jump into the second gate insulating film 6 as compared with a conventional structure in which electric charges travel in a direction approximately horizontal with respect to the semiconductor surface. This improves the efficiency at which hot carriers are absorbed into the floating gate electrode 7. On the other hand, the structure of the example is so constituted that electric charges can hardly jump into the first gate insulating film 5. Thus securing the dielectric strength of the edge portion in the longitudinal direction of the channel by using the LDD region 12 enables suppressing the generation of the avalanche breakdown on the side of the source region. This alleviates the restrictions imposed on the thickness of the gate insulating films, the erasing voltage and reading voltage thereby realizing a flexible high performance device.

Furthermore, as compared with the conventional flash memory, a thicker second gate insulating film and a thinner first gate insulating film improve the basic operation of the flash memory that is repeated in which data is written into the floating gate electrode with the electric field of the control gate electrode and data is erased with the electric field of the source electrode. Still furthermore, adjustment of the film feature of the gate insulating film and the capacitance coupling of the insulating film with each electrode or source and drain regions and the gate insulating film allows improvement of the basic operation.

Additionally, since the first gate insulating film is thinner than the second insulating film, in writing operation the channel below the first gate insulating film is more strongly inverted than the channel below the second gate insulating film. As a result, owing to the narrow channel under the thick oxide film region, electrons under the floating gate electrode can move more easily to facilitate the writing operation.

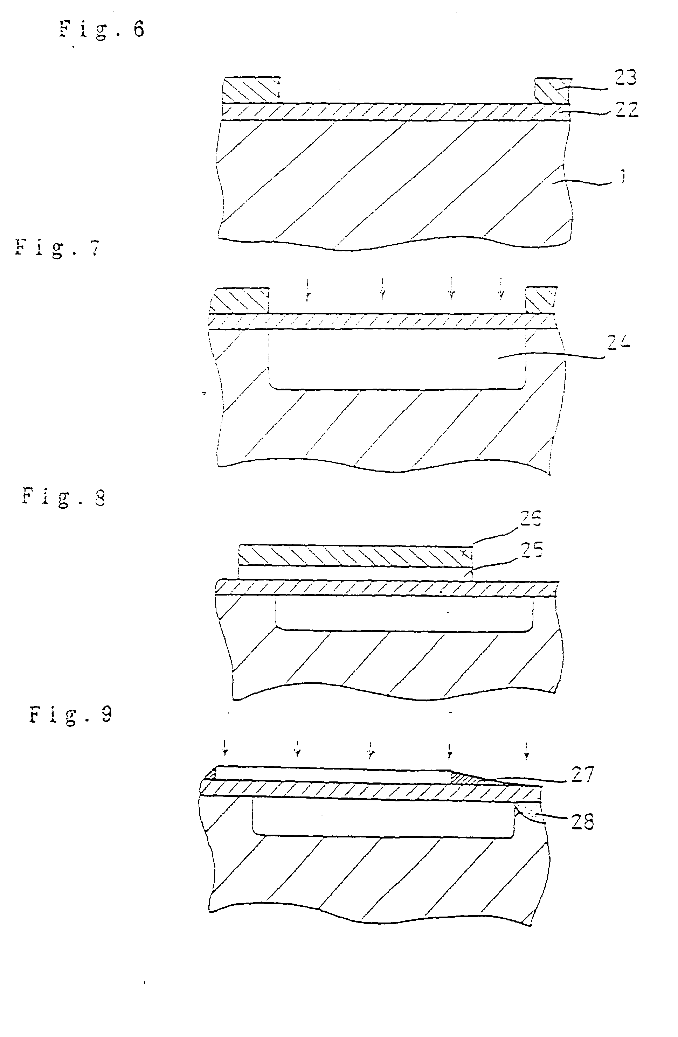

In the following section, a method for manufacturing the device shown in Fig.1 will be detailed. Figs. 6 through 20 are sectional views showing a single cell for use in illustrating a method for manufacturing a self-aligned non-volatile semiconductor (flash) memory device according to the present invention.

### Pretreatment for Forming Device Isolation Oxide Film

At the outset, as shown in Fig. 6, on a P-type silicon substrate 1 in which the surface oxygen concentration was sufficiently lowered by gettering or the like, a buffer oxide film 22 was grown to a thickness of 1000Å. To obtain a bird's beak length with an excellent reproducibility, and to alleviate a stress of $10^{10}$dyn/cm$^2$ in a silicon nitride film which was formed later or for the suppression of translocation or the generation of a slop in the silicon substrate, the buffer oxide film was preferably formed to a thickness of 1000Å or more. In this particular example, 0.8 micron long bird's beak length was formed. Subsequently, on the buffer oxide film 22, a photoresist pattern 23 was formed which was open only in the device formation region.

In the subsequently process, as shown in FIG. 7, boron was implanted in a dose amount of 5 X $10^{12}$ions/cm$^2$ and at an implantation energy of 100KeV to a sufficient depth (Rp 0.3 micron or more) which would not be affected by the tail of the profile formed by the implantation of a high concentration of boron. In this manner, a channel dope layer 24 was formed. Ions have to be implanted with an extremely clean device and in an extremely clean environment. Thus an ion implantation equipment was used which does not sputter heavy ions.

As shown in Fig. 8, the photoresist pattern was removed to deposit a silicon nitride film to a thickness of 1000Å which constitutes an antioxidant film. Then on the silicon nitride a photoresist pattern 26 was formed which was open only in a region where a device isolation oxide film was formed for isolating the device region into an island configuration. Selectively removing the silicon nitride film using the resist pattern 26 as a mask allowed the formation of a silicon nitride film pattern 25 which was open at a portion where the device isolation oxide film was formed.

Then, as shown in Fig. 9, after the resist pattern 26 was removed by etching, side wall spacers 27 for restricting the passage of ion implantation were formed on the side walls of the open part of the above silicon nitride film pattern 25. Subsequently, boron ions were implanted for the formation of a channel stopper at an implantation energy of 40KeV and in a dose amount of 5 X $10^{13}$ ions/cm$^2$ to form a field dope layer 28.

### Step of Forming Device Isolation Oxide Film

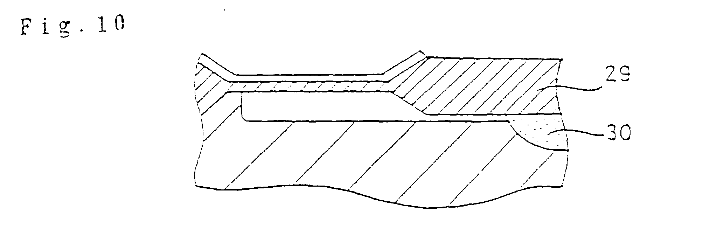

Then, as shown in Fig.10, the substrate was subjected to wet oxidation at 1000°C to grow a silicon oxide film on the exposed surface of the substrate 1, thereby forming a device isolation oxide film 29. In the formation process, boron atoms in the field dope layer 28 were activated and redistributed to form an inversion prevention layer 30 on the lower layer of the device isolation oxide film 29.

**Step of Forming an Active Region**

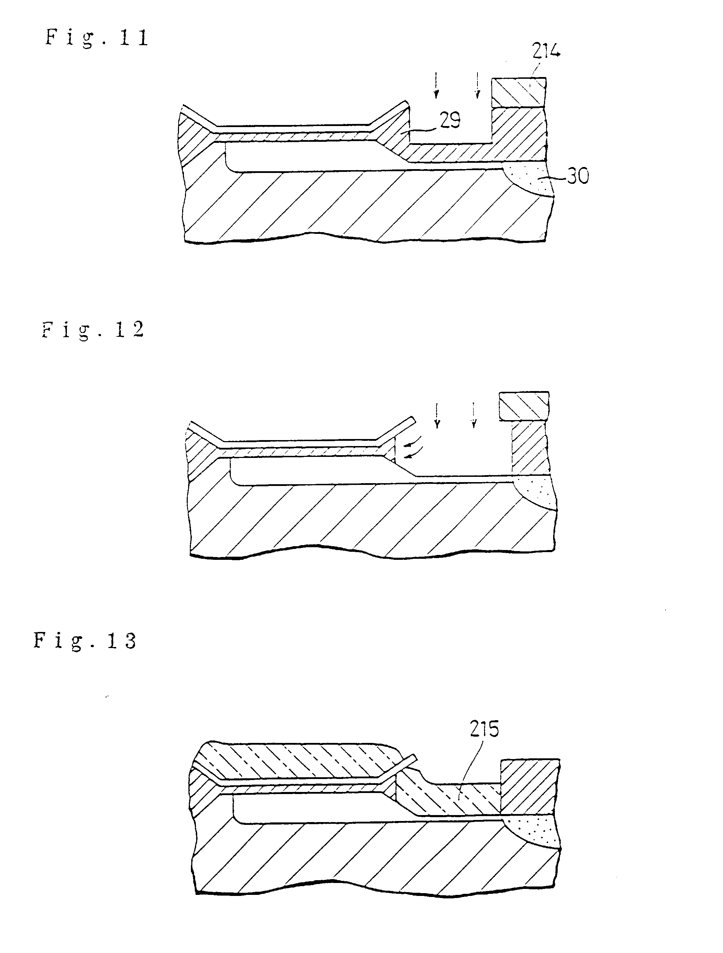

Next, after forming a resist pattern 214 as shown in FIG. 11, an anisotropic etching was conducted by using the resist pattern 214 and the silicon nitride film 25 as a mask to remove part of the device isolation oxide film 29. An isotropic etching followed to etch a predetermined amount of the device isolation oxide film 29 located under the silicon nitride film 25 as shown in Fig.12. Then, an SOG film 215 was coated to a thickness of 6000Å as shown in FIG. 13, while suitably etching back. The SOG film 215 which was formed on the silicon nitride film 25 was lifted off by etching the silicon nitride film 25 as shown in FIG. 14. The buffer oxide film 22 and the end portion of the device isolation oxide film 29 were removed as shown in FIG. 15

**Step of Forming First and Second Gate Insulating Films**

After the previous step, the whole surface was thermally oxidized at 900°C to form a first gate insulating film 5 and a second gate insulating film 6.

**Step of Forming a Floating Gate Electrode**

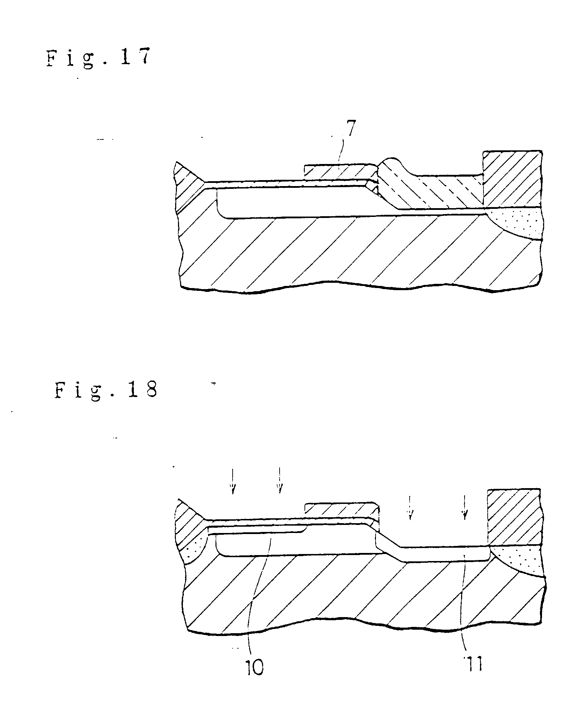

Then, polysilicon layer was deposited to a thickness of 1500Å on the whole surface and the polysilicon layer was etched using a resist pattern as a mask to form a floating gate electrode 7 as shown in FIG. 17.

**Step of Forming a Source and Drain Regions**

A source region 10 and the drain region 11 were formed as shown in FIG. 18 by implanting impurities at a high concentration using the LOCOS oxide film 22 and the floating gate electrode 7 as a mask. In this step, as the source region 10 was formed by implanting impurities through the gate insulating film 5, it was placed shallower than the drain region 11. Further, the dose amount in the floating gate electrode may be varied partially and the dose amount in the source and drain regions may be increased by implanting ions again to a part of the floating gate electrode (ex. drain side) using a mask for preventing ion implantation.

**Step of Forming a Third Gate Insulating Film**

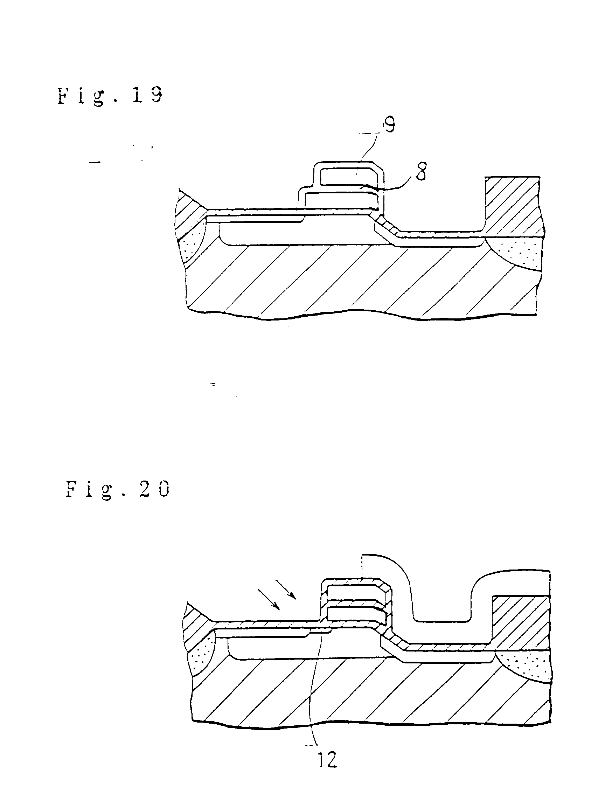

Further, the surface of the floating gate electrode 7 was oxidized to form a third gate insulating film 8 as shown in FIG. 19.

**Step of Forming a Control Gate Electrode**

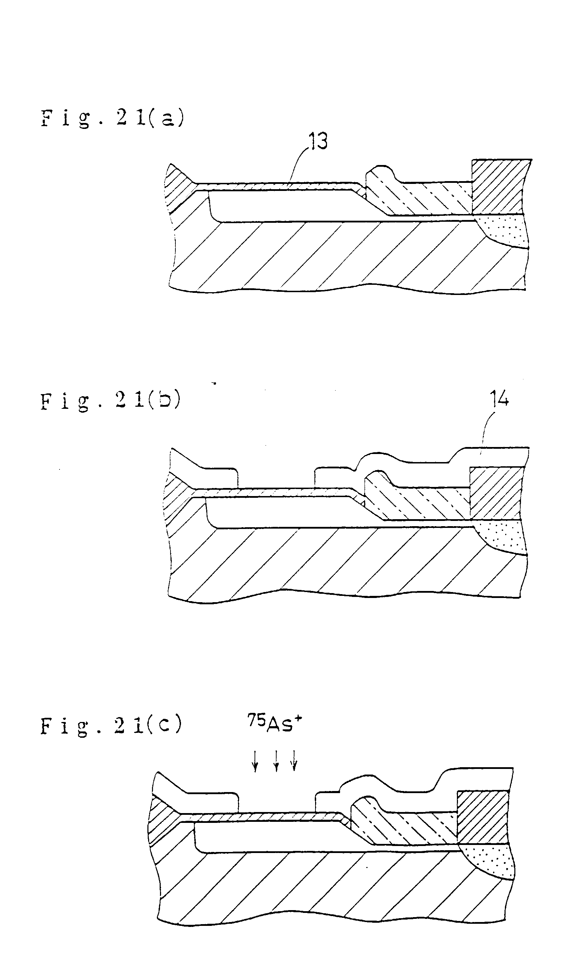

Then, polysilicon layer was formed on the whole surface and etched using a resist pattern and oxidized to form a control gate electrode 9. In order to reduce sheet resistance of polysilicon, arsenic ions may be implanted into the control gate electrode at 40 KeV in a dose amount of $3 \times 10^{15}$ /cm$^2$ , and a film of a silicide of a metal having a high melting point may be formed on the control gate electrode by the DC sputtering or the like. The ratio of the metal having a high melting point to silicon in the silicide (M/Si) was about 1/3. Then, the ends of the control gate electrode 9 and the floating gate electrode 7 were self-aligned as shown in FIG. 20 and the whole surface was subjected to oxidation. Next, impurities were implanted from an inclined direction while rotating the substrate to form an LDD structure 12 under the floating gate electrode 7 at the source region side. At a subsequent step, an interlayer insulating film 43 was formed in accordance with the normal process. A contact hole was opened on the substrate and the substrate was subjected to metallization 44 so that a passivation film (not shown in the drawings) was formed. Thus, a flash memory having a self-aligned structure was completed according to the present invention (see Fig. 1).

FIG. 39 shows a plan view of the flash memory shown in FIG. 1. In FIG. 39, reference numeral 15 designates a Fowler-Nordheim tunneling region, 16 a control gate line, 17 a floating gate electrode and a channel region.

The surface impurities concentration of the source region which overlaps the gate electrode preferably assumes $10^{18}$ ions/cm$^3$ or less in the LDD low concentration region and $10^{19}$ ions/cm$^3$ or more in the high concentration region when the gate insulating film has a thickness of 60 to 100Å. This is intended to inhibit an increase in the leak current caused by the Zener phenomenon in the impurity diffusion layer immediately below the gate electrode with respect to the thin gate insulating film of the embodiment.

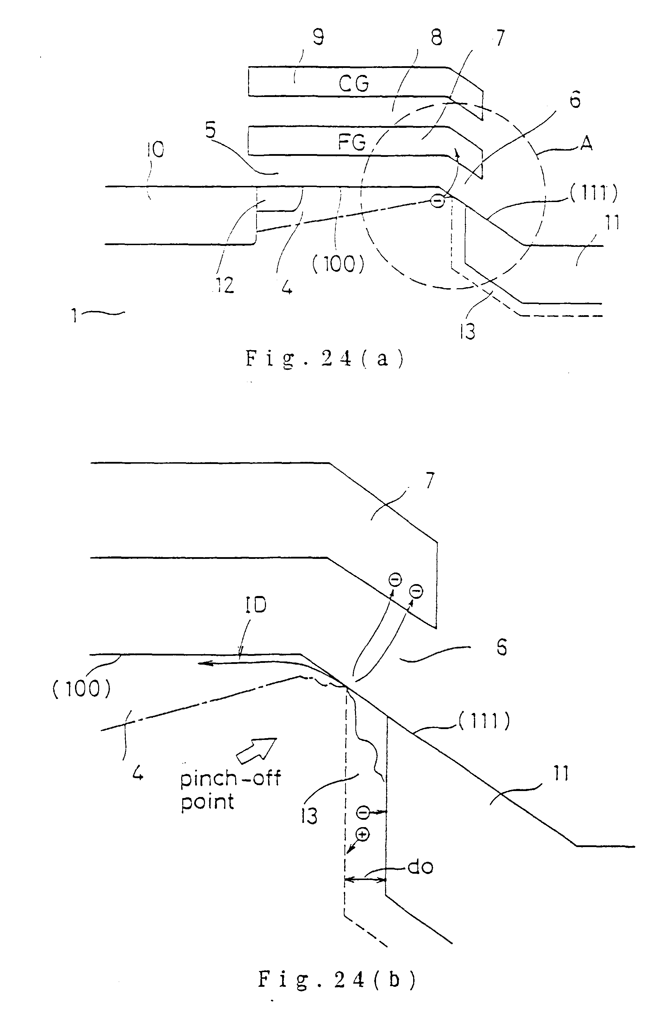

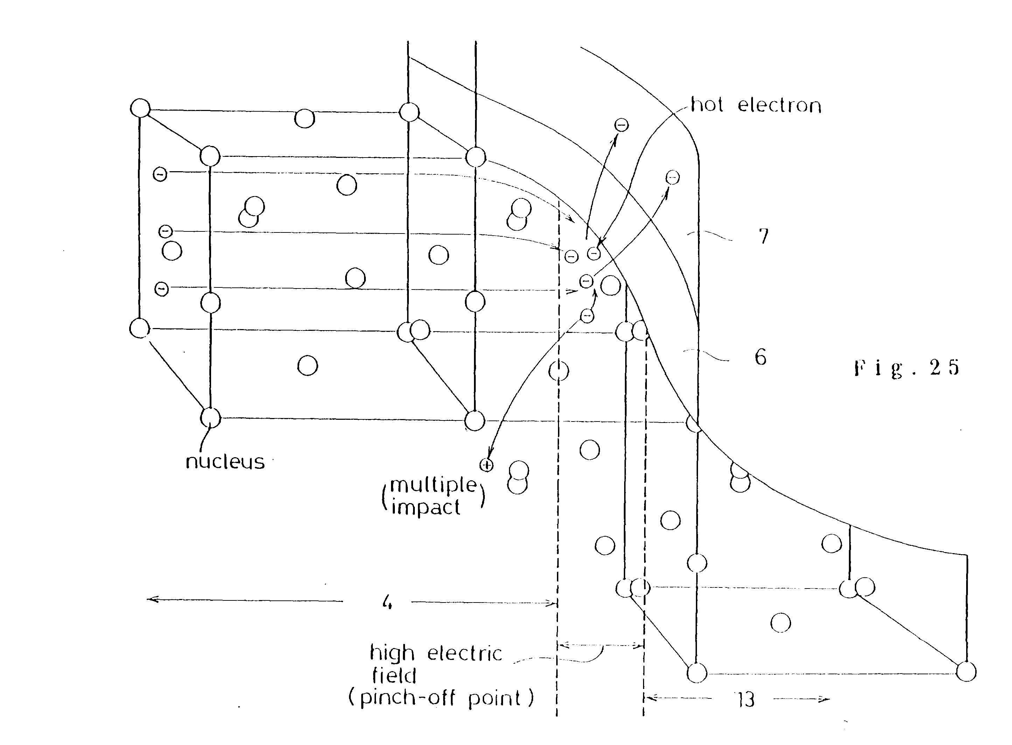

Further, the operation of a flash memory according to an embodiment of the present invention will be described as follows using Figs. 24(a), 24(b), and 25. Referring to Figs. 24 (a), 24(b), and 25, reference numeral 1 designates a P-type semiconductor substrate, 4 a channel region, 5 a first gate insulating film, 6 a second gate insulating film provided on the inclined portion and formed in the semiconductor substrate, 7 a floating gate electrode, 8 a third gate insulating film, 9 a control gate electrode, 10 a source region, 11 a drain region, 12 an LDD structure for improving insulating strength at an erasing operation, and 13 a depletion layer.

Referring to Figs. 24 (a), 24 (b), and 25, the direction in which electrons that have been traveling through the channel being accelerated from the source region to the drain region are bent in the configuration of the channel region when the electrons enter into the inclined portion. Consequently, a high electric field is generated as a result of the bent progression direction of the electrons in the substrate (bent in the dislocation composite defect portion resulting from an edge stress or the like at the LOCOS oxidation though it is difficult to describe it in an accurate way) and the overlapping of the end portion of the depletion layer of the drain region onto the inclined portion. The high electric field and the bent of the progression direction of electrons promote the generation of hot electrons.

In a cell in which the source region is provided relatively above the drain region, when a (100) silicon substrate is used, the inclined surface (approximate to a (111) surface) of the silicon substrate is used as a material to form a gate insulating film on the side of the drain region. Consequently, the top of the inclined surface on the drain region is formed thicker than the side of the source region in the same thermal oxidation process. This facilitates a countermeasure against an error in erasure at the time of reading data as compared with a device in which the drain region is located above the source region. In other words, the process for forming the impurity layer to obtain a thick gate insulating film on the side of the drain region can be omitted which is regarded as the most difficult on the practical level.

Further, with regard to unification of power supplies and reduction of the voltage applied, an advantage of the device manufactured according to the method described above as shown in Figs. 24 (a), 24(b), and 25 will be explained as follows in conjunction with a writing operation of the hot carrier injection type. At the outset, positive voltages Vd and Vcg are applied to the drain region and the control gate electrode respectively. At this time, assuming that the substrate and the source region have the same potential and an equation of Vs=0, the current Id flowing through the channel region can be approximated by the following equation.

$$Id = \frac{\mu n \cdot \varepsilon ox \cdot W}{2(d1 \cdot l1 + d2 \cdot l2)} (Vf-Vt)^2$$

Here symbol d1 designates a thickness of the gate insulating film in the planar channel region, d2 a thickness of the gate insulating film in the inclined channel region, ox a conductivity thereof, μn a mobility of electrons, l1 effective channel length of the planar channel region, and W a channel width. For the sake of convenience it is assumed that the conductivity of the gate insulating film in the planar channel region and that of the gate insulating film in the inclined channel region are about the same.

Symbol Vt designates a threshold voltage with respect to the floating gate electrode, which depends on the effective channel length l.

Symbol Vf designates a potential of the floating gate electrode, which is represented by the following formula;

$$Vf = \frac{Cfc \cdot Vc + Cfd \cdot Vd - Qf}{Cfs + Cfss1 + Cfss2 + Cfd + Cfc}$$

Here, symbol Cfs designates the capacity between the floating gate electrode and the source region. Symbol Cfssl designates the capacity between the floating gate electrode and the inclined channel region. Symbol Cfss2 designates the capacity between the floating gate electrode and the planar channel region. Symbol Cfd designates the capacity between the floating gate electrode and the drain region, and Cfc the capacity between the floating gate electrode and the control gate electrode. Symbol Qf designates an quantity of electric charges generated in the floating gate electrode when electric currents flowing through the channel region are accelerated in the electric field between the source and the drain regions and electrons which acquired sufficient energy are injected into the floating gate electrode. The electric charge designated by symbol Qf depends on the rate at which hot carriers are injected into the gate insulating film. The time integral of Id at the channel current of Id is given by the following formula:

$$Qf = \int_0^T \gamma Id \ dt$$

At this time, the intensity of the electric field in the gate insulating film is given by the following formula:

$$Eox = \frac{Cfs + Cfss1 + Cfss2 + Cfd}{Cfs + Cfss1 + Cfss2 + Cfd + Cfc} \cdot \frac{Cfc \cdot Vc + Cfd \cdot Vd - Qf}{S1 \cdot \varepsilon ox}$$

Thus the time integral of the above can be approximated by the following formula:

$$\frac{d\,E\,ox}{d\,t} \approx \frac{\gamma\,\beta}{\varepsilon\,1}\left(\frac{\varepsilon\,1\cdot E\,o\,x}{C\,fs + C\,fss1 + C\,fss2 + C\,fd + C\,fc}\right)^{2}$$

In the above formula,

$$\varepsilon1 = S1 \cdot \varepsilon ox \cdot \frac{Cfs+Cfss1+Cfss2+Cfd+Cfc}{Cfs+Cfss1+Cfss2+Cfd}$$

Symbol S1 designates a sum of the area of the effective channel length ($[l1+l2]W$) and the overlapped area of the floating gate electrode and the source region. The writing time of the memory transistor Tw can be represented by a function of the following formula by integrating the sum.

$$\frac{(Cfs+Cfss1+Cfss2+Cfd+Cfc)^{2}}{\gamma\,\beta\,\varepsilon1}$$

Since Cfss1 and Cfss2 are determined by the thicknesses d1 and d2 and by the adjustment of l1 and l2 to optimal values, the writing time adjustment can be facilitated by controlling these values compared with the conventional structure. As described above, a bent is generated in the channel current with the result that the injection efficiency can be improved at that portion.

Three operations such as writing, erasing and reading data will be described which constitute the basic operations of the flash memory hereinbelow.

The writing operation will be explained initially. When a voltage of 5 V is applied to the drain region and a voltage of 12V is applied to the control gate electrode after the source region is grounded, electrons flowed from the source region to the drain region at a high electric field, and electrons are then generated which can exceed an energy barrier from the silicon surface to the insulating film in the neighborhood of the drain region. In the structure of the present invention, the source region is formed at a region relatively upper than the drain region with the result that the electrons in the high electric field are directed to the insulating film in the neighborhood of the drain region at a predetermined angle. Consequently, the electrons are more easily absorbed by the electric field of the control gate electrode, which improves the writing performance of the flash memory.

The erasing operation can be performed in the same manner as the conventional method. Application of an erasing voltage results in the discharge of the electric field from the floating gate electrode to the side of the source region. The insulating film in the neighborhood of the source region is thinned down to about 10nm, so that the erasing speed can be heightened. The quantity of the electrons extracted is adjusted by the control circuit to have an appropriate value, and the threshold value of the cell is determined.

Data can be read from the flash memory by checking the presence of current which flows from the drain region when a voltage of 5V is applied tc the drain region and the control gate electrode. At this time, the gate insulating film is covered almost completely with a thick gate insulating film. On top of that, the insulating film for erasure which is located in the neighborhood of the source region that has been thinned is formed with an inclination thereby making it difficult for F-N tunneling to be generated. Thus, application of a voltage to the drain region over a long time enables the prevention of an erred erasure of data.

Since no control gate electrode is formed on the drain region with respect to a device in which a floating gate electrode extends over the drain region with an insulating film sandwiched therebetween, erred erasure of data is out of the question. However, in such a case the insulating film has to be formed thicker than the gate insulating film.

**Example 2**

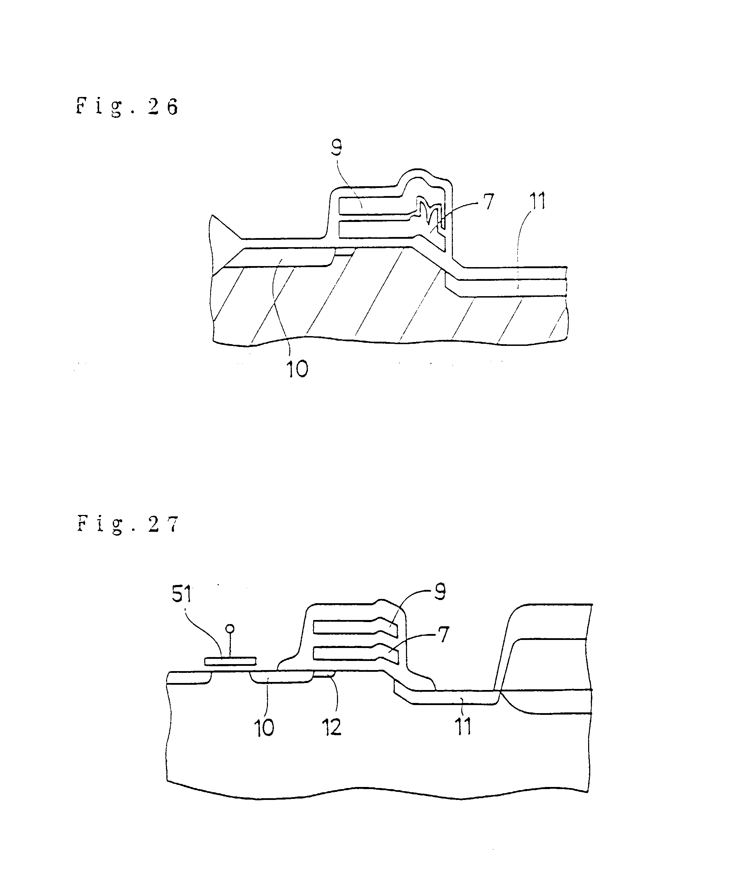

FIG. 26 is a schematic sectional view showing the flash memory according to one example of the present invention. A surface area on the upper part of the floating gate electrode of the drain region side is enlarged to a size larger than the surface area of the upper part of the source region side.

The flash memory is manufactured in the same manner as Example 1 except that the flash memory is manufactured according to the following method.

At the outset, a floating gate electrode is formed and then an oxide film is formed thereon. Subsequently, a resist pattern is formed which has an opening on the floating gate electrode of the drain region side. The resist pattern is used as a mask to remove the oxide film at the opening by RIE. After polysilicon is laminated on the entire surface of the substrate, the substrate is etched back by anisotropic etching, thereby removing polysilicon deposited on a portion other than the side wall of the opening of the insulating film. Furthermore, the removal of the oxide film results in the formation of a floating gate electrode having a projecting part.

## Example 3

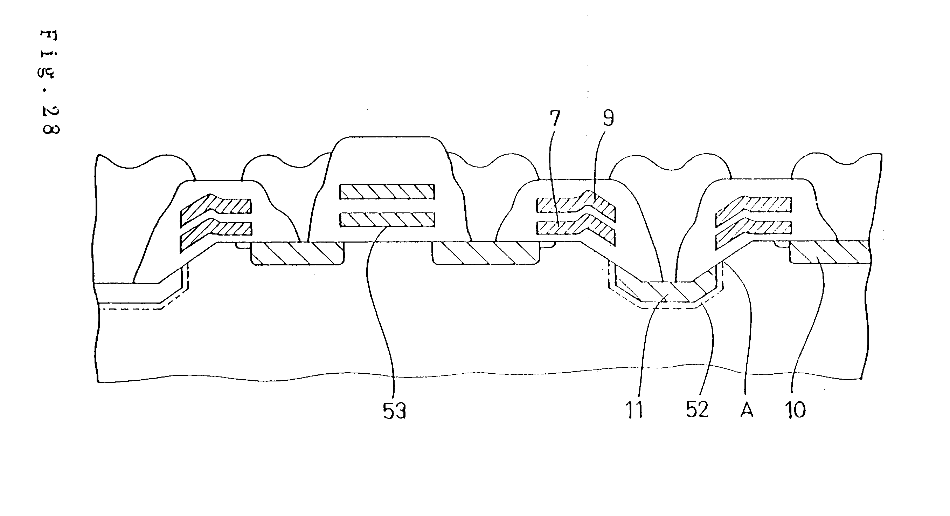

FIG. 27 is a view showing one example in which the device isolation by the device isolation oxide film on one side is replaced by the device isolation by the gate electrode 51. A third gate insulating film is formed in such a manner that the insulating film is thin on the side of the drain region and thick on the side of the source region. The flash memory allows improving the drawing efficiency of the control gate electrode.

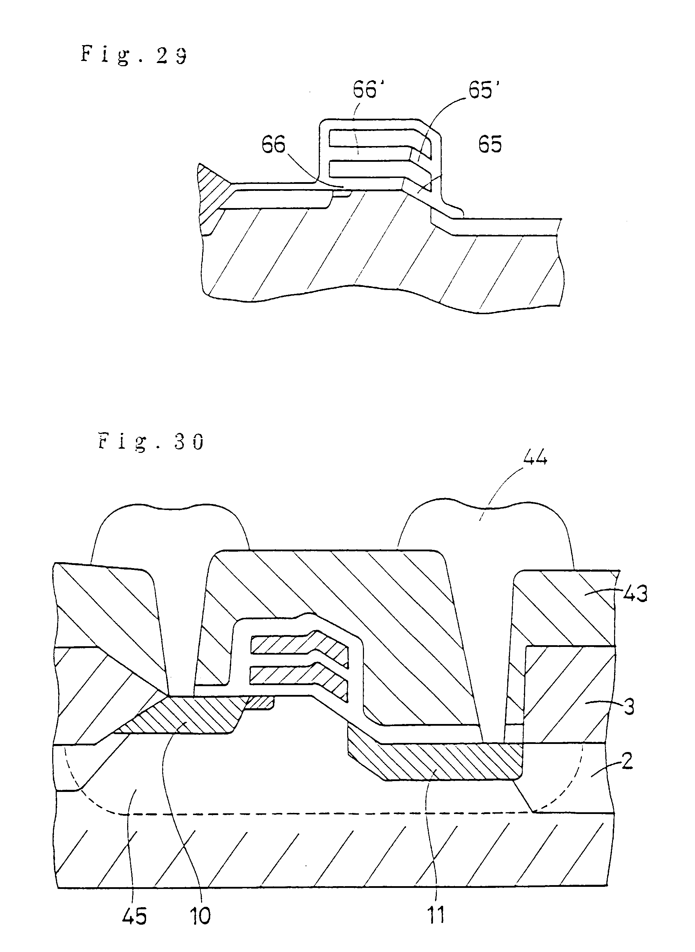

According to FIG. 28, device isolation was realized by the gate 53. According to the manufacturing process of this device, the LOCOS oxide film was removed, then the floating gate electrode and the device isolation gate were formed in a same process, and using the gates as a mask the source region and the drain region were formed. With such a structure, electric conduction between adjacent source regions was flexibly realized by the device isolation gate 53. Alternatively, the device isolation gate can be replaced by a floating gate electrode and a control gate electrode. In this case the degree of device isolation can be determined by changing the quantity of electric charges accumulated in the floating gate electrode.

## Example 4

FIG. 29 is a view showing one example of the flash memory in which the same advantage is provided by selectively implanting phosphorus impurities and forming insulating films having different dielectric constants instead of changing the thickness of the first and the second gate insulating films. In this particular example, the dielectric constant of the first gate insulating film 65 was 3.9 whereas the dielectric constant of the second gate insulating film 66 was 3.5.

## Example 5

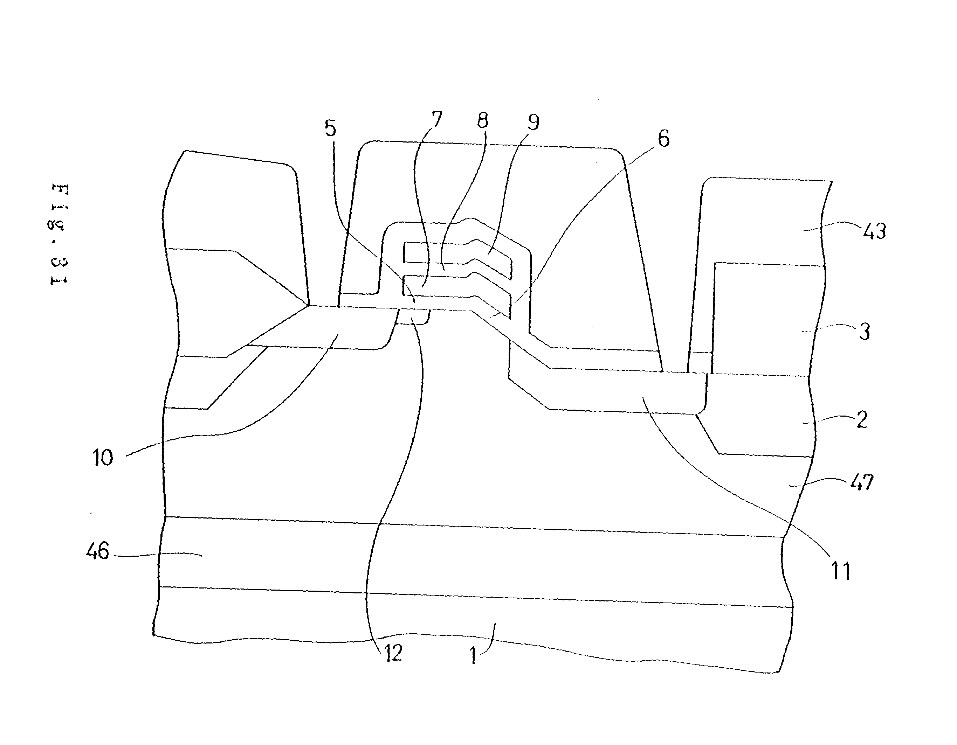

Moreover, as shown in FIG. 30, a device shown in FIG. 1 might be formed in a well 45. The conductive type of this well might be of the same as or the reverse of that of the substrate.

## Example 6

Alternatively, as shown in FIG. 31, a device shown in FIG. 1 might be formed in a double well consisting of an N well 46 (e.g. with phosphorus as impurities and a dose amount of $1 \times 10^{12}$ to $1 \times 10^{13}$ /cm$^2$) and a P well 47 (e. g. with boron as impurities and a dose amount of $1 \times 10^{13}$ to $1 \times 10^{14}$ /cm$^2$). In this way the electric potential of each well can be separately controlled and, further, the voltage of the control gate electrode can be reduced by applying a negative bias to the P well.

## Example 7

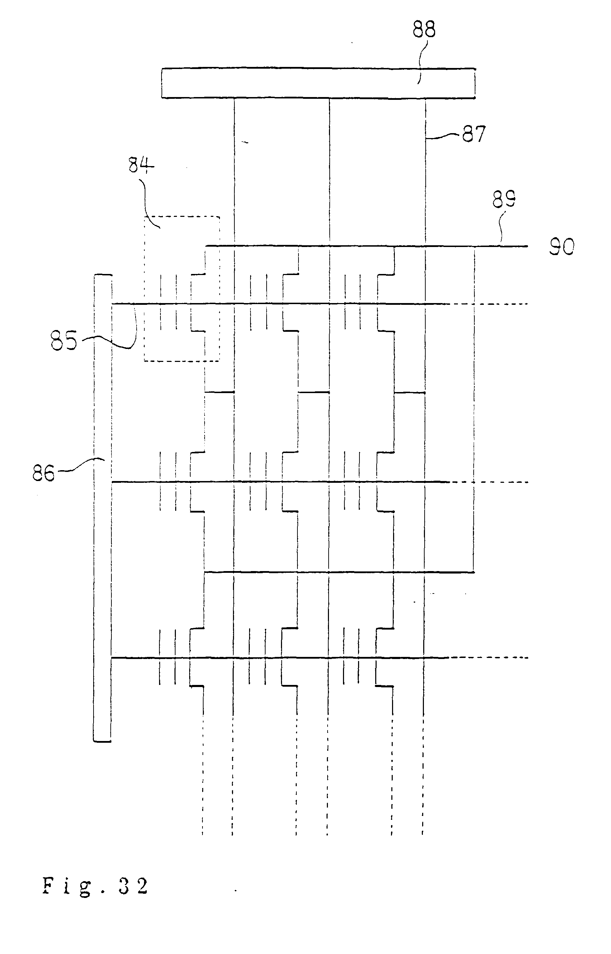

As shown in FIG. 32, the flash memory of an embodiment of the present invention could be arranged in matrix. Incidentally, FIG. 32 shows a memory cell array of NOR type. Referring to FIG. 32, reference numeral 84 designates a memory site where the flash memory of an embodiment of the present invention was arranged, 85 a row address line, and a signal line wired from a row address decoder 86. Reference numeral 87 designates a column address line, and a signal line wired from a column address decoder 88. Reference numeral 89 designates an erasing line, and a signal line wired from a source decoder 90.

## Example 8

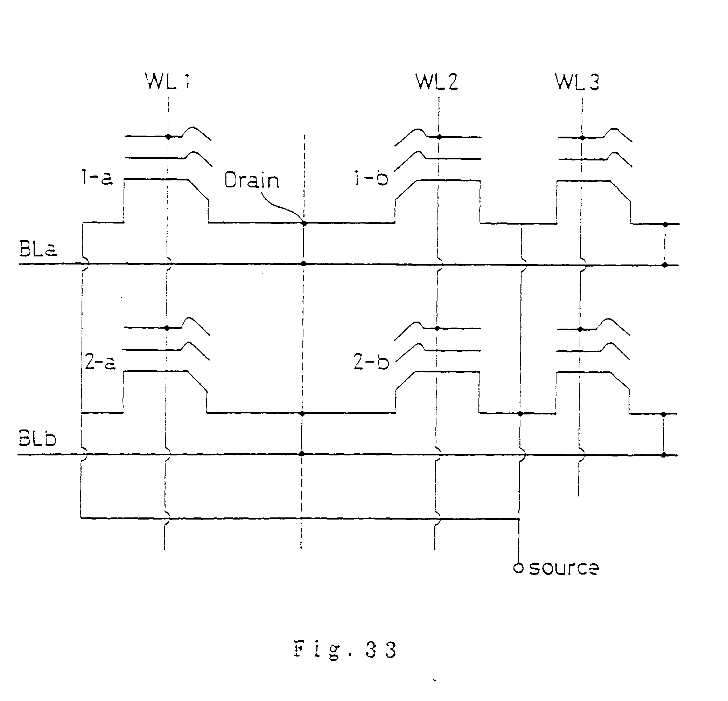

Referring to FIG. 33, a further embodiment of the present invention will be illustrated.

At the outset, when the threshold value of cell 1-a which has been programmed at the time of writing operation is 5V (which means that the threshold value of the cell has risen from 1V to 5V by the injection of the impact ionized hot electrons into the floating gate electrode), 0V (non-selective) is applied to the word line WL1 and 12V (selective) is applied to the word line WL2 for writing data into cell 1-b, and 6V is applied to BLa.

Consequently, between the drain region and the floating gate electrode in the cell 1-a, the sum of 6V applied to the BLa and a voltage generated by an electric charge that can raise 1V of an accumulated threshold voltage in the floating gate electrode to 5V, is then applied (for example, 6+4V). This means that a voltage approximating to 10V (somewhat reduced in actuality due to the relation between each capacity) is applied between the drain region and the floating gate electrode when the cell 1-a in which data has been written serves for writing data into the cell 1-b.

In the flash memory of an embodiment of the present invention in which the drain regions serve as bit lines provide cells which receive a voltage approximate to 10V between the drain region and the floating gate electrode at a frequency corresponding to the number of cells connected to the bit lines.

On the other hand, each of these cells receives 13V when data is erased from the memory thereby eliminating the electric charge.

It is hard to say that there is a large difference between the voltage applied between the drain region and the floating gate electrode at the time of writing data into the cell 1-a and the voltage applied between the source region and the floating gate at the time of erasing data.

This generates a problem in that data in the cell is erased when data is written into different cells commonly connected to the drain region. However, in accordance with the present invention data is erased through Fowler-Nordheim tunneling, the tunnel distance (thickness of the gate insulating film) can be extended when the barrier height (difference in voltage) cannot be enlarged.

In other words, to facilitate an erasure in erasing operation and prevent an erred erasure in writing operation, cells can be formed having a thick gate insulating film on the drain side and a thin one on the source side, and then bilaterally arranged and connected with respect to the drain region thereby forming a memory cell matrix.

**Example 9**

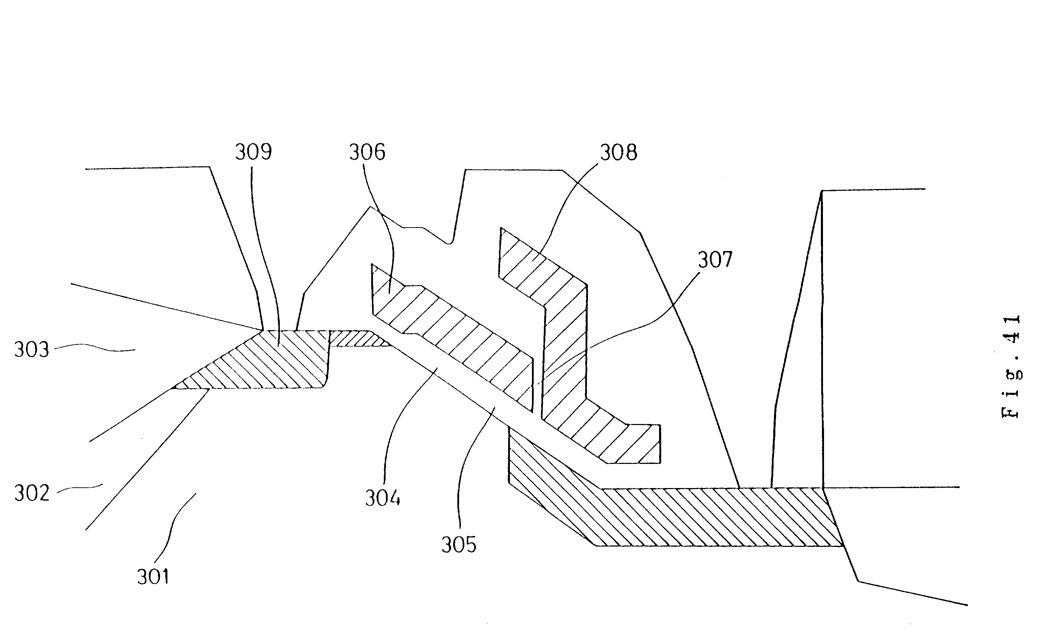

FIG. 40 shows a thin film transistor as an embodiment of the invention.

Namely, an inclined portion was formed in the P type silicon substrate 1 with impurity concentration of about $10^{15}$ /cm$^3$, and SiO$_2$ (an insulating film) 48 was grown to a thickness of about 5000Å. Subsequently, amorphous silicon 49 was formed to a thickness of 400Å and then ions were implanted so that the arsenic impurity concentration in the source and drain regions (10 and 11) are about $10^{21}$ /cm$^3$, and the boron impurity concentration in the channel region was about 4 X $10^{16}$ /cm$^3$. The gate oxide film was formed to a thickness of 200Å by vapor deposition, and a polisilicon floating gate electrode 7 of about 2000Å was formed so that the phosphorus impurity concentration was about $10^{20}$ to $10^{21}$ /cm$^3$.

Subsequently, an interlayer insulating film of about 150Å was formed, and a polisilicon control gate electrode 9 with thickness of about 3000Å was formed, so as to yield a thin film transistor as shown in FIG. 40. Here, preferably the phosphorus impurity concentration of the control gate electrode is higher than that of the floating gate electrode 7. By applying the structure of the present invention, parasitic capacitance of bit lines can be reduced and junction currents can be reduced.

**Example 10**

Fig. 41 shows a sectional view of a flash memory cell according to Example 10 of the present invention, in which reference numeral 301 designates P-type semiconductor substrate, 302 a field dope layer, 303 a device isolation oxide film (LOCOS), 304 a channel region, 305 a gate insulating film, 306 a first polysilicon layer (a floating gate electrode), 307 an interlayer insulating film, 308 a second polysilicon layer (a control gate electrode), 309 a source region (N$^+$-type impurity region), 310 a drain region (N$^+$-type impurity region).

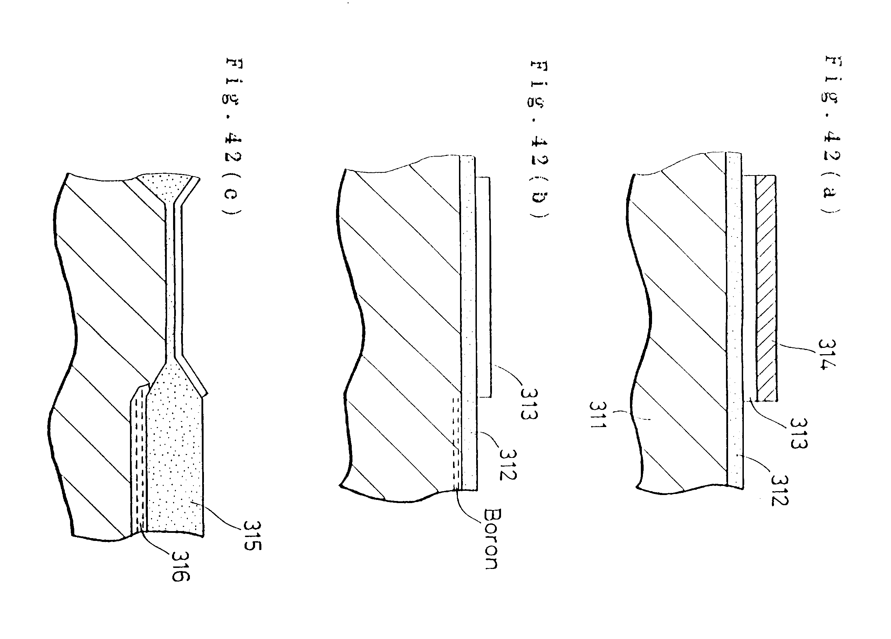

The manufacturing process of the memory cell of Example 10 of the present invention is described in detail by Fig. 42 (a) through Fig. 46 (c).

At the outset, on a P-type silicon substrate 311 that was pretreated by gettering or the like to have sufficiently reduced surface oxygen concentration and reduced crystal defects, a buffer oxide film 312 was formed to a thickness of 1000 Å. Subsequently, a silicon nitride film 313 was deposited to a thickness of 1000Å as an antioxidant film. Then, on the silicon nitride film 313, a photoresist pattern 314 was formed which was open only in the region where a device isolation oxide film was to be formed to isolate device regions in an island-like configuration. Using this pattern as a mask, a pattern comprising the above silicon nitride film pattern 313 was formed (see Fig. 42(a)).

Subsequently, after the resist pattern 314 was removed with etching, side wall spacers (not shown) for inhibiting the ions to pass through during ion implantation were formed on the side walls of the pattern by coating SOG on the entire surface. Then, a field dope layer was formed by implanting boron at an implantation energy of 40 KeV and in a dose amount of 5 x $10^{13}$ /cm$^2$ to form a channel stopper (see Fig. 42(b)).

After a wet oxidation at a temperature 1000°C, a silicon oxide film was grown on the exposed surface of the substrate 311 to form a device isolation oxide film 315. In this process, boron atoms in the above field dope layer were activated and redistributed to form an inversion prevention layer 316 under the device isolation oxide film 315 (see Fig.42 (c)).

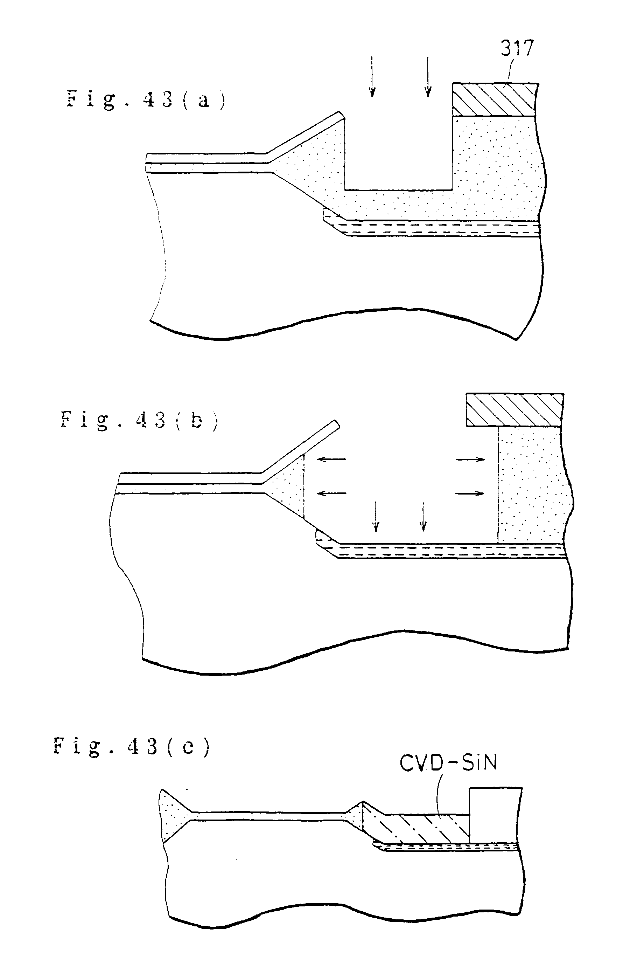

Then, after a resist pattern 317 was formed, some parts of the device isolation oxide film 315 were removed by anisotropic etching with the resist pattern 317 and the silicon nitride film 313 used as a mask (see Fig. 43(a)).

Subsequently, by isotropic etching, the bird's beak oxide film under the silicon nitride film 313 was etched to a predetermined amount (for determining the predetermined position of the drain region side of the floating gate electrode) (see Fig. 43(b)).

Further, after the silicon nitride film 313 was removed with etching, a plasma CVD nitride film was deposited to a thickness of 5000Å on the entire surface. Further, after covering the device isolation region 315 and an opening 318 of the device isolation region with a photoresist, the plasma CVD nitride film on the buffer oxide film and the oxide film at the end of the bird's beak was removed (see Fig. 43(c)).

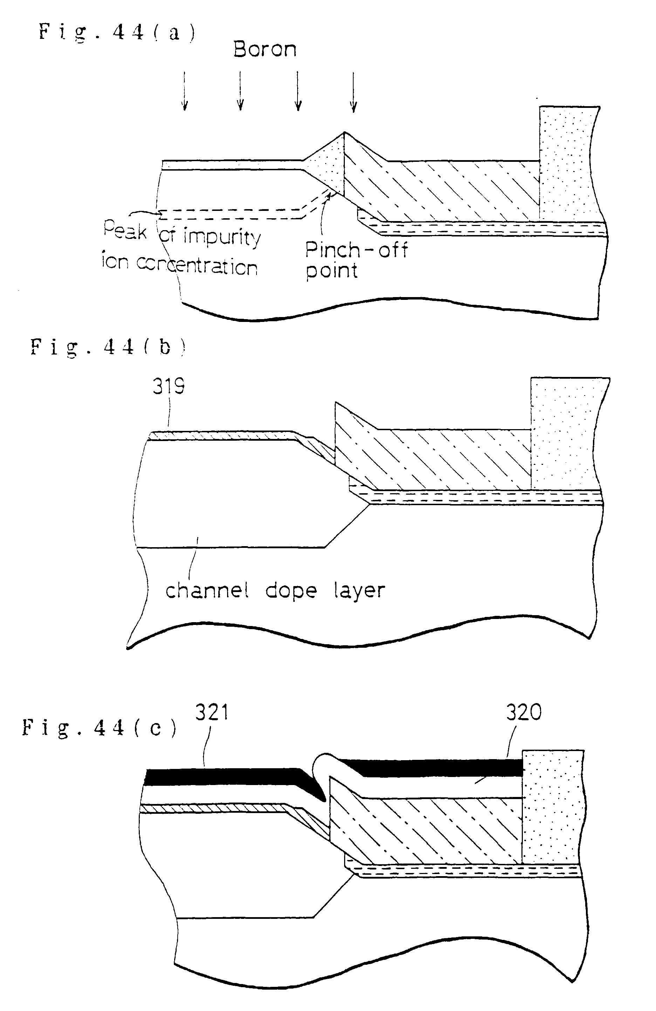

At this stage, boron was implanted at an implantation energy of 100 KeV and in a dose amount of 5 x $10^{12}$ /cm$^2$, thereby implanting ions through the oxide film 315 into the substrate below the edge (the bird's beak oxide film) of the device isolation oxide film, so as to form a concentration gradient in the inclined channel region (see Fig. 44(a)).

Then, the buffer oxide film and the edge of the device isolation oxide film were removed. Afterwards, the entire surface was thermally oxidized at a temperature 900°C to form a gate oxide film 319. This gate oxide film 319 was formed thinner on the source region side so as to provide a thin oxide film of the Fowler-Nordheim tunnel region (see Fig. 44(b)).

Subsequently, a polysilicon layer 320 was deposited to a thickness of 1500Å on the entire surface, and then SOG 321 was coated, exposing the polysilicon only at the step portion (the edge of the nitride film), as shown in Fig. 44(c). Then the exposed unnecessary part of the polysilicon was removed.

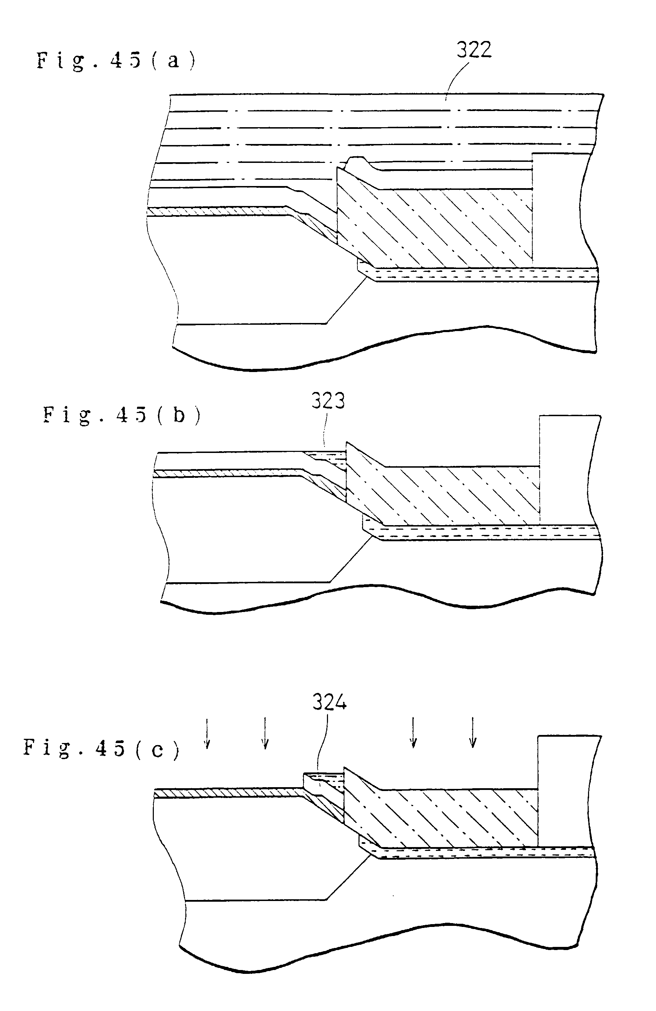

Afterwards, a CVD oxide film with good step-coverage was flatly deposited, by repeating etch-back at least more than once (see Fig. 45 (a)).

Then, isotropic etching was applied until the surface of the above polysilicon layer 320 was exposed. Here, the CVD oxide film 323 still remains on the above polysilicon layer formed at the inclined portion of the channel region (see Fig. 45 (b)).

Next, by anisotropic reactive etching using hydrogen bromide (HBr) or the like having sufficient polysilicon selectivity over oxide films, the exposed polysilicon 320 was selectively etched to form a floating gate electrode 324 (see Fig. 45(c)).

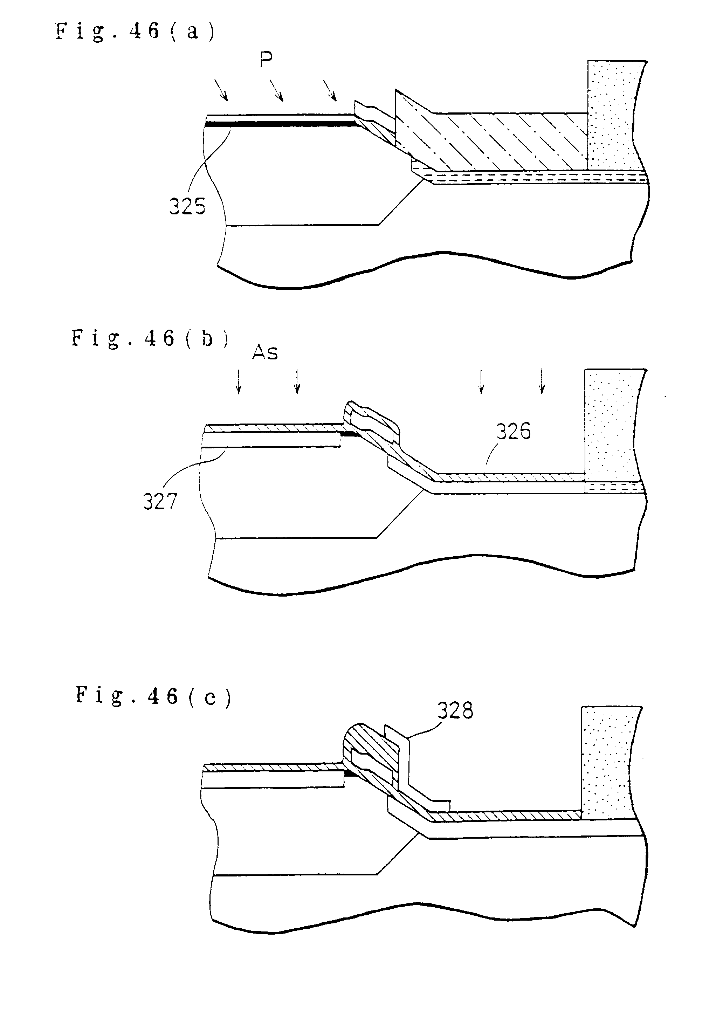

Subsequently, using the floating gate electrode 324 and the CVD oxide film 323 as a mask, phosphorus was rotationally implanted at low concentration and low energy, so as to form an N$^-$ diffusion layer 325 (see Fig. 46(a)).

An interlayer insulating film 326 was formed by oxidizing the exposed surface of the floating gate electrode 324 and the substrate. Afterwards, using the floating gate electrode 324 as a mask, arsenic (As) was implanted at high concentration to form a source region and a drain region 327 (see Fig. 46(b)).

Then, a nitride film was formed on the entire surface, and isotropic and anisotropic etching was applied to the nitride film to form the nitride film side wall spacers on the side walls of the floating gate electrode to prevent oxidation. After an oxidation process which formed an interlayer insulating film with a thickness 1000Å or more on the floating gate electrode, the nitride film side wall spacers were removed. Afterwards, an etching process was applied until the thin oxide film on the side walls was sufficiently over-etched, and then, after a pretreatment, a thin interlayer insulating film was formed with good precision on the side wall of the floating gate electrode. In this process sacrificial oxidation improves reliability. Then, polysilicon was deposited on the entire surface to form a control gate electrode (word-line) 328 (see Fig. 46(c)).

Then, in order to reduce the sheet resistance of the polysilicon of the control gate electrode 328, arsenic (As) was implanted into the control gate electrode at an implantation energy of 40KeV and in a dose amount of 3 x $10^{15}$ / cm$^2$. Then, on the control gate electrode 328, a silicide of a metal having a high melting point was formed. The composition of the metal having a high melting point with respect to the silicon (M/Si) in the silicide was about 1/3.

After oxidation on the entire surface, an interlayer insulating film was formed in accordance with a normal process, followed by opening a contact hole, performing a metallization, and protecting by a passivation film, thereby completing a flash memory device having a hyper-fine floating gate and a structure of an inclined channel type according to the present invention.

With respect to a non-volatile memory according to the present invention, the drain region is positioned at least partially below the source region, which enables substantially extending the channel length. Then the present invention has an advantage that a punch-through hardly occurs compared with a conventional device formed according to the same two-dimensional design rule.

Furthermore, the present invention can provide a non-volatile memory that has a small area and a high writing/erasing speed, and can prevent erroneous erasure in reading operations. Moreover, being excellent for mass production and miniaturization, and having an outstanding durability in frequent writing/erasing and reading operations, the non-volatile memory according to the present invention has a tremendous industrial value as a memory for image processing in which simple operations and the like of a large amount of data are frequently executed, or as a device that replaces a magnetic memory.

Besides, according to the manufacturing process of a non-volatile memory of the present invention, a highly precise and thin insulating film can be formed with good reproducibility and non-volatile memories having high durability and reliability can be produced.

According to a non-volatile memory of the present invention in which the floating gate electrode is located above the inclined part of the channel region, the floating gate electrode can be formed, without photoetching, to have an extremely small structure, thereby making it possible to diminish the size of a memory cell to a great extent, with a result that the memory shows excellence for mass production.

According to the manufacturing method of the above non-volatile memory of the present invention, a floating gate highly precise and miniature in size can be formed with good reproducibility, so that a non-volatile memory excellent in durability and reliability can be produced.

## Claims

1.  A non-volatile semiconductor memory comprising:

    a substrate (1) including at least a first surface region, a second surface region located below the first surface region, and an inclined region connecting the first surface region and the second surface region;
    a source region (10) formed at least in the first surface region;
    a drain region (11) formed at least in the second surface region;
    a channel region (4) between the source region (10) and the drain region (11) and formed in the inclined region;
    a first dielectric film (5) formed on the first surface region;
    a second dielectric film (6) formed on the inclined region;
    a floating gate (7); and
    a control gate (9) formed in contact with the floating gate (7) through the intermediary of a third dielectric film (8),

    characterised in that the floating gate (7) has at least a portion which is formed along the inclined second dielectric film (6) and extends at a level below the upper surface of the first dielectric film (5).

2.  A non-volatile semiconductor memory as claimed in claim 1, characterised in that the floating gate (7) has at least a portion which is formed on the second dielectric film (6) and at the level below the upper surface of the first surface region.

3.  A non-volatile semiconductor memory as claimed in claim 1 or 2, characterised in that the channel region (4) is located in a surface of the inclined region.

4.  A non-volatile semiconductor memory as claimed in claim 3, characterised in that the width of the inclined channel region (4) is 20 nm to 800 nm and the height of the inclined channel region (4) is 10 nm to 500 nm.

5.  A non-volatile semiconductor memory as claimed in any one of claims 1 to 4, characterised in that the source region (10) has a low concentration impurity diffusion region and a high concentration impurity diffusion region.

6.  A non-volatile semiconductor memory as claimed in claim 5, characterised in that the low concentration impurity diffusion region is formed in the first surface region.

7.  A non-volatile semiconductor memory as claimed in any one of claims 1 to 6, characterised in that the non-volatile semiconductor memory is a thin film transistor.

8.  A non-volatile semiconductor memory as claimed in any one of claims 1 to 7, characterised in that the drain region (11) is formed also in the inclined region.

9.  A non-volatile semiconductor memory as claimed in any one of claims 1 to 8, characterised in that the control gate (9) is positioned above the second surface region.

**10.** A non-volatile semiconductor memory as claimed in claim 10, characterised in that the control gate (9) is positioned above the first surface region.

**11.** A non-volatile semiconductor memory as claimed in any one of claims 1 to 10 wherein the thickness of the second dielectric film (6) is greater than or equal to the thickness of the first dielectric film (5).

**12.** A non-volatile memory array comprising a plurality of memories as claimed in any one of claims 1 to 11, wherein two adjacent memories have a common drain region (11) and are positioned as mirror images about the drain region (11).

**13.** A method of forming a non-volatile semiconductor memory as claimed in claim 1 comprising:

providing a substrate (1) including at least a first surface region, a second surface region located below the first surface region, and an inclined region connecting the first surface region and the second surface region;
forming a source region (10) at least in the first surface region;
forming a drain region (11) at least in the second surface region;
forming a first dielectric film (5) formed on the first surface region;
forming a second dielectric film (6) on the inclined region of the substrate (1);
forming a floating gate (7) having at least a portion on the inclined second dielectric film (6) and at a level below the upper surface of the first dielectric film (5); and
forming a control gate (9) formed in contact wish the floating gate (7) through the intermediary of a third dielectric film (8).

**14.** A method as claimed in claim 13 wherein the substrate (1) including the inclined region is formed by carrying out the steps of :

forming a first oxide film on a substrate;
forming a silicon nitride film selectively on a region of the first oxide film where the first surface region is to be formed;
carrying out wet oxidation using the silicon nitride film as a mask to form a second oxide film having a larger thickness than the first oxide film; and
etching the first and second oxide films.

**Patentansprüche**

**1.** Nichtflüchtiger Halbleiterspeicher mit:

- einem Substrat (1) mit mindestens einem ersten Oberflächenbereich, einem zweiten Oberflächenbereich, der unter dem ersten liegt, und einem schrägen Bereich, der den ersten Oberflächenbereich mit dem zweiten verbindet;
- einem Sourcebereich (10), der zumindest im ersten Oberflächenbereich ausgebildet ist;
- einem Drainbereich (11), der zumindest im zweiten Oberflächenbereich ausgebildet ist;
- einem Kanalbereich (4) zwischen dem Sourcebereich (10) und dem Drainbereich (11), der im schrägen Bereich ausgebildet ist;
- einem ersten dielektrischen Film (5), der auf dem ersten Oberflächenbereich ausgebildet ist;
- einem zweiten dielektrischen Film (6), der auf dem schrägen Bereich ausgebildet ist;
- einem potentialungebundenen Gate (7) und
- einem Steuergate (9), das unter Einfügung eines dritten dielektrischen Films (8) in Kontakt mit dem potentialungebundenen Gate (7) ausgebildet ist;

**dadurch gekennzeichnet,** dass das potentialungebundene Gate (7) mindestens einen Abschnitt aufweist, der entlang dem schrägen zweiten dielektrischen Film (6) ausgebildet ist und sich auf einem Niveau unter der Oberfläche des ersten dielektrischen Films (5) erstreckt.

**2.** Nichtflüchtiger Halbleiterspeicher nach Anspruch 1, **dadurch gekennzeichnet,** dass das potentialungebundene Gate (7) über mindestens einen Abschnitt verfügt, der auf dem zweiten dielektrischen Film (6) auf einem Niveau unter der Oberfläche des ersten Oberflächenbereichs ausgebildet ist.

3.  Nichtflüchtiger Halbleiterspeicher nach Anspruch 1 oder 2, **dadurch gekennzeichnet,** dass der Kanalbereich (4) in einer Fläche des schrägen Bereichs liegt.

4.  Nichtflüchtiger Halbleiterspeicher nach Anspruch 3, **dadurch gekennzeichnet**, dass die Breite des schrägen Kanalbereichs (4) 20 nm bis 800 nm und die Höhe desselben 10 nm bis 500 nm betragen.

5.  Nichtflüchtiger Halbleiterspeicher nach einem der Ansprüche 1 bis 4, **dadurch gekennzeichnet,** dass der Sourcebereich (10) über einen Fremdstoff-Diffusionsbereich niedriger Konzentration und einen Fremdstoff-Diffusionsbereich hoher Konzentration verfügt.

6.  Nichtflüchtiger Halbleiterspeicher nach Anspruch 5, **dadurch gekennzeichnet**, dass der Fremdstoff-Diffusionsbereich niedriger Konzentration im ersten Oberflächenbereich ausgebildet ist.

7.  Nichtflüchtiger Halbleiterspeicher nach einem der Ansprüche 1 bis 6, **dadurch gekennzeichnet**, dass er ein Dünnfilmtransistor ist.

8.  Nichtflüchtiger Halbleiterspeicher nach einem der Ansprüche 1 bis 7, **dadurch gekennzeichnet,** dass der Drainbereich (11) auch im schrägen Bereich ausgebildet ist.

9.  Nichtflüchtiger Halbleiterspeicher nach einem der Ansprüche 1 bis 8, **dadurch gekennzeichne**t, dass das Steuergate (9) über dem zweiten Oberflächenbereich positioniert ist.

10. Nichtflüchtiger Halbleiterspeicher nach Anspruch 10, **dadurch gekennzeichnet,** dass das Steuergate (9) über dem ersten Oberflächenbereich positioniert ist.

11. Nichtflüchtiger Halbleiterspeicher nach einem der Ansprüche 1 bis 10, bei dem die Dicke des zweiten dielektrischen Films (6) größer als oder gleich groß wie die Dicke des ersten dielektrischen Films (5) ist.

12. Nichtflüchtiges Speicherarray mit einer Anzahl von Speichern nach einem der Ansprüche 1 bis 11, bei dem zwei benachbarte Speicher einen gemeinsamen Drainbereich (11) aufweisen und sie spiegelbildlich zu diesem positioniert sind.

13. Verfahren zum Herstellen eines nichtflüchtigen Halbleiterspeichers nach Anspruch 1, umfassend:

    -   Bereitstellen eines Substrats (1) mit mindestens einem ersten Oberflächenbereich, einem zweiten Oberflächenbereich unter dem ersten und einem schrägen Bereich, der den ersten Oberflächenbereich mit dem zweiten verbindet;
    -   Herstellen eines Sourcebereichs (10) zumindest im ersten Oberflächenbereich;
    -   Herstellen eines Drainbereichs (11) zumindest im zweiten Oberflächenbereich;
    -   Herstellen eines ersten dielektrischen Films (5) auf dem ersten Oberflächenbereich;
    -   Herstellen eines zweiten dielektrischen Films (6) auf dem schrägen Bereich des Substrats (1);
    -   Herstellen eines potentialungebundenen Gates (7) mit mindestens einem Abschnitt auf dem schrägen zweiten dielektrischen Film (6) und auf dem Niveau unter der Oberfläche des ersten dielektrischen Films (5); und
    -   Herstellen eines Steuergates (9) in Kontakt mit dem potentialungebundenen Gate (7) unter Einfügung eines dritten dielektrischen Films (8).

14. Verfahren nach Anspruch 13, bei dem das Substrat (1) mit dem schrägen Bereich dadurch hergestellt wird, dass die folgenden Schritte ausgeführt werden:

    -   Herstellen eines ersten Oxidfilms auf einem Substrat;
    -   Herstellen eines Siliziumnitridfilms in selektiver Weise auf einem Bereich des ersten Oxidfilms, in dem der erste Oberflächenbereich herzustellen ist;
    -   Ausführen von Feuchtoxidation unter Verwendung des Siliziumnitridfilms als Maske zum Herstellen eines zweiten Oxidfilms mit größerer Dicke als der des ersten Oxidfilms; und
    -   Ätzen des ersten und zweiten Oxidfilms.

**Revendications**

1. Mémoire à semi-conducteur non volatile comprenant :

   un substrat (1) comportant au moins une première région de surface, une seconde région de surface située sous la première région de surface, et une région inclinée reliant entre elles la première région de surface et la seconde région de surface ;
   une région de source (10) formée au moins dans la première région de surface ;
   une région de drain (11) formée au moins dans la seconde région de surface ;
   une région de canal (4) située entre la région de source (10) et la région de drain (11) et formée dans la région inclinée ;
   un premier film diélectrique (5) formé sur la première région de surface ;
   un second film diélectrique (6) formé sur la région inclinée ;
   une grille flottante (7) ; et
   une grille de commande (9) formée de façon à être en contact avec la grille flottante (7) par l'intermédiaire d'un troisième film diélectrique (8),

   caractérisée en ce que la grille flottante (7) comporte au moins une partie qui est formée le long du second film diélectrique incliné (6) et qui s'étend à un niveau situé en dessous de la surface supérieure du premier film diélectrique (5).

2. Mémoire à semi-conducteur non volatile selon la revendication 1, caractérisée en ce que la grille flottante (7) comporte au moins une partie qui est formée sur le second film diélectrique (6) et à un niveau situé en dessous de la surface supérieure de la première région de surface.

3. Mémoire à semi-conducteur non volatile selon la revendication 1 ou la revendication 2, caractérisée en ce que la région de canal (4) est située dans une surface de la région inclinée.

4. Mémoire à semi-conducteur non volatile selon la revendication 3, caractérisée en ce que la largeur de la région de canal inclinée (4) est comprise entre 20 nm et 800 nm et la hauteur de la région de canal inclinée (4) est comprise entre 10 nm et 500 nm.

5. Mémoire à semi-conducteur non volatile selon l'une quelconque des revendications 1 à 4, caractérisée en ce que la région de source (10) comporte une région de diffusion d'impuretés de faible concentration et une région de diffusion d'impuretés de forte concentration.

6. Mémoire à semi-conducteur non volatile selon la revendication 5, caractérisée en ce que la région de diffusion d'impuretés de faible concentration est formée dans la première région de surface.

7. Mémoire à semi-conducteur non volatile selon l'une quelconque des revendications 1 à 6, caractérisée en ce que la mémoire à semi-conducteur non volatile est un transistor à couche mince.

8. Mémoire à semi-conducteur non volatile selon l'une quelconque des revendications 1 à 7, caractérisée en ce que la région de drain (11) est également formée dans la région inclinée.

9. Mémoire à semi-conducteur non volatile selon l'une quelconque des revendications 1 à 8, caractérisée en ce que la grille de commande (9) est positionnée au-dessus de la seconde région de surface.

10. Mémoire à semi-conducteur non volatile selon la revendication 9, caractérisée en ce que la grille de commande (9) est positionnée au-dessus de la première région de surface.

11. Mémoire à semi-conducteur non volatile selon l'une quelconque des revendications 1 à 10, dans laquelle l'épaisseur du second film diélectrique (6) est supérieure ou égale à l'épaisseur du premier film diélectrique (5).

12. Groupement de mémoires non volatiles comprenant une multiplicité de mémoires selon l'une quelconque des revendications 1 à 11, dans lequel deux mémoires adjacentes ont une région de drain commune (11) et sont positionnées de façon symétrique de part et d'autre de la région de drain (11).

**13.** Procédé de formation d'une mémoire à semi-conducteur non volatile selon la revendication 1, comprenant les étapes consistant à :

prévoir un substrat (1) comprenant au moins une première région de surface, une seconde région de surface située sous la première région de surface, et une région inclinée reliant entre elles la première région de surface et la seconde région de surface ;
former une région de source (10) au moins dans la première région de surface ;
former une région de drain (11) au moins dans la seconde région de surface ;
former un premier film diélectrique (5) sur la première région de surface ;
former un second film diélectrique (6) sur la région inclinée du substrat (1) ;
former une grille flottante (7) comportant au moins une partie située sur le second film diélectrique incliné (6) et à un niveau situé en dessous de la surface supérieure du premier film diélectrique (5) ; et
former une grille de commande (9) en contact avec la grille flottante (7) par l'intermédiaire d'un troisième film diélectrique (8).

**14.** Procédé selon la revendication 13, dans lequel le substrat (1) comprenant la région inclinée est formé par exécution des étapes consistant à :

former un premier film d'oxyde sur un substrat ;
former un film de nitrure de silicium de façon sélective sur une région du premier film d'oxyde où la première région de surface doit être formée ;
effectuer une oxydation en milieu liquide en utilisant le film de nitrure de silicium comme masque pour former un second film d'oxyde ayant une épaisseur supérieure à celle du premier film d'oxyde ; et
attaquer chimiquement les premier et second films d'oxyde.

Fig. 1

Fig. 2(a)

Fig. 2(b)

Fig. 2(c)

Fig. 2(d)

Fig. 2(e)

Fig. 3

9

5

7

10

37

38

6

11

Fig. 4

(At erasing)

Substrate Substrate

Drain        37        38        Control gate

C5          C3        C2        C4

C1

Source Vse (erasing voltage)

Fig. 5

(At writing)

Drain    Substrate    Substrate    Source

C5          C3          C2          C1

C4

Control gate Vsg (writing voltage)

Fig. 6

Fig. 7

Fig. 8

Fig. 9

Fig.10

29

30

Fig. 11

Fig. 12

Fig. 13

Fig. 14

Fig. 15

Fig. 16

Fig. 17

Fig. 18

Fig. 19

Fig. 20

Fig. 21(a)

13

Fig. 21(b)

14

Fig. 21(c)    $^{75}As^+$

↓ ↓ ↓

F i g . 2 2(a)

F i g . 2 2(b)

F i g . 2 2(c)

F i g . 2 3(a)

10   12      11

F i g . 2 3(b)

9

8

12

F i g . 2 3(c)

12

Fig. 24(a)

Fig. 24(b)

Fig. 25

hot electron

7

6

(multiple)
(impact)

nucleus

high electric
field
(pinch-off point)

13

Fig. 26

Fig. 27

Fig. 28

Fig.29

Fig.30

Fig. 31

Fig. 32

Fig. 33

Fig. 34
(Prior Art)

Fig. 35
(Prior Art)

Fig. 36
(Prior Art)

F i g . 3 7(a)

F i g . 3 7(b)

Fig. 38

Fig. 39

Fig. 40

Fig. 41

Fig. 42(a)

Fig. 42(b)

Fig. 42(c)

EP 0 718 895 B1

Fig. 43(a)

317

Fig. 43(b)

Fig. 43(c)

CVD-SiN

52

Fig. 44 (a)

Boron

Peak of impurity
ion concentration

Pinch-off
point

Fig. 44 (b)

319

channel dope layer

Fig. 44 (c)   321                    320

Fig.45(a)

322

Fig.45(b)

323

Fig.45(c)

324

Fig. 46(a)

Fig. 46(b)

Fig. 46(c)